(19) Europäisches Patentamt / European Patent Office / Office européen des brevets

(11) **EP 2 846 464 B1**

(12) **EUROPEAN PATENT SPECIFICATION**

(45) Date of publication and mention
of the grant of the patent:
**09.01.2019 Bulletin 2019/02**

(21) Application number: **13784450.2**

(22) Date of filing: **30.04.2013**

(51) Int Cl.:
**H03K 17/08** *(2006.01)* **H03K 17/687** *(2006.01)*

(86) International application number:
**PCT/JP2013/062661**

(87) International publication number:
**WO 2013/165004 (07.11.2013 Gazette 2013/45)**

(54) **OVERCURRENT PROTECTION POWER SUPPLY APPARATUS**

STROMVERSORGUNGSVORRICHTUNG MIT ÜBERSTROMSCHUTZ

APPAREIL D'ALIMENTATION ÉLECTRIQUE AVEC PROTECTION CONTRE LES SURINTENSITÉS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.05.2012 JP 2012104973
06.03.2013 JP 2013044793**

(43) Date of publication of application:
**11.03.2015 Bulletin 2015/11**

(73) Proprietor: **Ohshima, Shunzou
Aichi 441-0213 (JP)**

(72) Inventor: **Ohshima, Shunzou
Aichi 441-0213 (JP)**

(74) Representative: **Kramer Barske Schmidtchen
Patentanwälte PartG mbB
European Patent Attorneys
Landsberger Strasse 300
80687 München (DE)**

(56) References cited:
**EP-A1- 1 693 942 JP-A- 2006 060 971
JP-A- 2008 283 641 JP-A- 2009 071 370
JP-A- 2010 056 602 US-A- 5 905 615
US-A1- 2005 157 441 US-A1- 2011 019 323
US-A1- 2011 110 009**

EP 2 846 464 B1

**Description**

FIELD OF THE INVENTION

This invention relates to a power supply apparatus for supplying electric power from a direct current power source (DC power source) to a load via a field effect transistor (FET), and more particularly, to a power supply apparatus having a function of protecting circuit elements of the power supply apparatus and the load against an overcurrent.

BACKGROUND

EP 1 693 942 A1 discloses an overcurrent detection device. US 2011/0019323 A1 discloses a protective device for a load circuit.

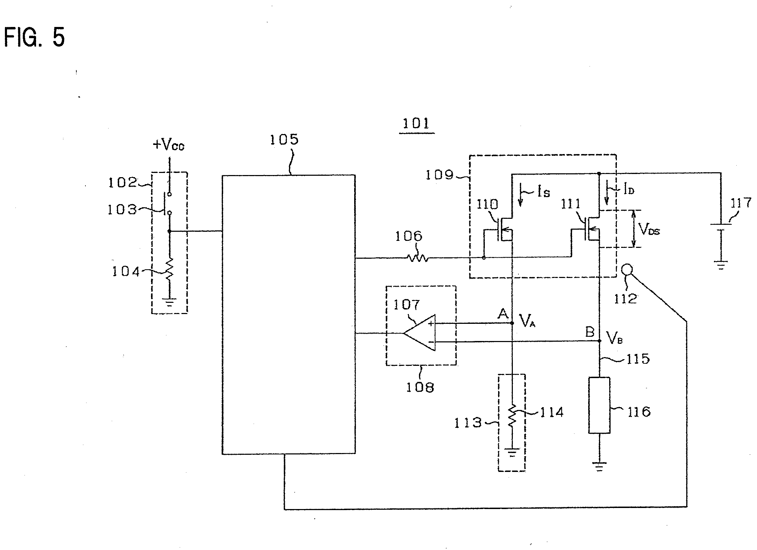

An overcurrent protection power supply apparatus disclosed in Japanese Patent No. 3706515 is shown in Fig. 5. The overcurrent protection power supply apparatus 101 shown in Fig. 5 comprises a switch circuit 102, a control circuit 105, an overcurrent detecting circuit 108, a multi-source FET 109 and a temperature sensor 112. The multi-source FET 109 has N type metal oxide semiconductor field effect transistors (N type MOSFET: NMOSFET) 111 and 110. The temperature sensor 112 detects a temperature of the MOSFET 111.

This overcurrent protection power supply apparatus 101 is used as a power supply apparatus for supplying electric power from a relatively low voltage DC power source 117, such as a 12V or 24V DC power source installed in a vehicle, to a load.

The overcurrent protection power supply apparatus 101 operates as follows.

When the switch 103 is turned on, the control circuit 105 turns on the MOSFETs 110, and 111, so that electric power is supplied from the DC power source 117 to the load 116.

If a current $I_D$ flowing through the MOSFET 111 increases excessively, a drain-source voltage generated between a drain and a source of the MOSFET 111 increases and so a detecting voltage $V_B$ decreases. When the detecting voltage $V_B$ becomes less than a reference voltage $V_A$, an output of a comparator 107 becomes a high level ("H"). Namely, an overcurrent detecting signal is output from the comparator 107. When the overcurrent detecting signal is output from an overcurrent detecting circuit 108, the control circuit 105 turns off the MOSFETs 111 and 110.

Also, the control circuit 105 turns off the MOSFETs 111 and 110, when determining that a temperature of the MOSFET 111 exceeds a predetermined temperature by a temperature signal from the temperature sensor 112.

For example, if an insulating film at a gate of either the MOSFET 111 or 110 is damaged partially, a leak current may flow between the gate and the source. When the leak current increases, a voltage drop across a resistor 106 increases, so that source-gate voltages of the MOSFET 111 and the MOSFET 110 decrease. Thus, the MOSFETs 111 and 110 generate heat due to increasing of an on-resistance. In this situation, since the current $I_D$ does not increase even if it decreases, the overcurrent detecting signal does not output from the overcurrent detecting circuit 108. As a result, a heat generation state of each of the MOSFET 111 and 110 is continuing and so the MOSFET 111 and 110 may be damaged. The temperature sensor 112 is provided in order to protect the MOSFETs against overheating.

PRIOR ART DOCUMENTS

Patent documents

Japanese Patent No. 3706515

SUMMARY OF THE INVENTION

Problem to be solved by the invention

If the conventional overcurrent protection power supply apparatus as mentioned above is used as a power supply apparatus for supplying electric power from a high voltage DC power source, e.g. a 500V DC power source installed in an electric vehicle or a hybrid vehicle, etc., to a load, there are following problems.

When a ground fault happens to occur, a ground resistance (ground fault resistance) is 20 to 50 milli ohm (m$\Omega$). The conventional overcurrent protection power supply apparatus takes about 10 micro seconds ($\mu$s) (protection operating time) from an occurrence of the ground fault to a turn-off of the MOSFET. So, if the voltage of the DC power source is 12V (hereinafter referred to as the "12V power source system"), a magnitude of a current (ground current or ground fault current) may reach about 100A during the protection operating time (about 10 micro second ($\mu$s)). On the other hand, if the voltage of the DC power source is 500V (hereinafter referred to as the "500V power source system"), the magnitude of the current (ground current) may reach about 1500A during the protection operating time (about 10 micro second

($\mu$s)). Namely, the magnitude of the current (ground current) which flows in the 500V power source system is about 15 times larger than the magnitude of the current (ground current) which flows in the 12V power source system.

A ground current (I) flows through a current path which has inevitably an inductance (L), so that the current path accumulates electromagnetic energy represented by [L $\times$ I$^2$ / 2]. This electromagnetic energy is consumed by being transformed into heat at the MOSFET 111 which has been turned-off. Since the magnitude of the overcurrent which flows in the 500V power source system is about 15 times larger than the magnitude of the overcurrent which flows in the 12V power source system, as mentioned above, the electromagnetic energy accumulated in the 500V power source system is about 225 times (15 $\times$ 15 = 225) larger than that accumulated in the 12V power source system. Namely, the MOSFET 111 used in the 500V power source system is heated with the electromagnetic energy which is 225 times larger than that in the 12V power source system.

Like this, when the voltage of the DC power source is high, the magnitude of the overcurrent which flows through the MOSFET is larger and the electromagnetic energy by which the MOSFET is heated is larger than those when the voltage of the DC power source is low. Therefore, it is difficult to protect sufficiently the MOSFET against the overcurrent.

Therefore, as for the power supply apparatus which supplies electric power from the high voltage DC power source, e.g. a 500V DC power source higher than a 12V or a 24V DC power source, to the load, a semiconductor switching element such as a MOSFET is hardly used, but a mechanical switching element such as a mechanical relay is used.

Means to solve the problem.

An overcurrent protection power supply apparatus of the present invention has a power switching element and a control circuit. A FET (Field Effect Transistor), typically, MOSFET (Metal Oxide Field Effect Transistor) is used as the power switching element. And the overcurrent protection power supply apparatus is configured to perform overcurrent protection operation for protecting the FET against an overcurrent based on a magnitude of a drain-source voltage generated between a drain and a source of the FET and an increasing rate of the magnitude of the drain-source voltage.

A first invention comprises a FET, a control circuit, a drain-source voltage detecting circuit, a drain source voltage detection starting circuit, a first overcurrent protection signal generating circuit and a second overcurrent protection signal generating circuit.

The drain-source voltage detecting circuit detects a drain-source voltage generated between a drain and a source of the FET by flowing of a drain current through the FET. The term "a drain-source voltage" means "a magnitude of a drain-source voltage" unless otherwise noted. And, the expression "detect a drain-source voltage" means "detect a magnitude of a drain-source voltage" or "detect a value corresponding to a magnitude of a drain-source voltage". Furthermore, a configuration of "detecting a drain-source voltage" includes an aspect of "outputting a magnitude of a drain-source voltage" or "outputting a result of comparing a magnitude of a drain-source voltage with a threshold value".

When turning on the FET to start the supply of electric power to the load, the drain-source voltage detection starting circuit starts the drain-source voltage detecting operation of the drain-source voltage detecting circuit after the drain-source voltage of the FET increases with an increase of the drain current of the FET. The drain current of the FET is nearly equal to the source current of the FET. Thus, in this specification, the drain current and the source current of the FET are collectively called "the drain current". The drain-source voltage detection starting circuit contributes to prevent the FET from shutting down incorrectly when a rush current flows.

The first overcurrent protection signal generating circuit outputs a first overcurrent protection signal based on the drain-source voltage of the FET, typically, when the drain-source voltage has increased.

The second overcurrent protection signal generating circuit outputs a second overcurrent protection signal based on an increasing rate of the drain-source voltage, typically, when the increasing rate of the drain-source voltage has increased.

The second overcurrent protection signal generating circuit measures a time interval from a time when the drain-source voltage becomes larger than a first threshold value to a time when the drain-source voltage becomes larger than a third threshold value which is larger than the first threshold value. Then, a reference time interval is set which is longer than the measured time interval. And, when the drain-source voltage becomes larger than a fourth threshold value which is larger than the third threshold value within the reference time interval from the time when the drain-voltage becomes larger than the first threshold value, the second overcurrent protection signal is output. The term "larger" may include "equal".

The control circuit turns off the FET to perform overcurrent protection operation when the first overcurrent protection signal or the second overcurrent protection signal is output.

The first invention performs the overcurrent protecting operation based on the drain-source voltage of the FET with the first overcurrent protection signal and based on the increasing rate of the drain-source voltage of the FET with the second overcurrent protection signal and thereby can surely protect the FET against the overcurrent. Therefore, even if supplying electric power from a high voltage DC power source, such as a 500V DC power source, to a load, a FET can be used as a power switching element.

The first invention can securely prevent the major overcurrent from flowing through the FET while it can prevent the FET from shutting down incorrectly when a rush current flows.

When the second overcurrent protection signal generating circuit is used together with the first overcurrent protection signal generating circuit of the modification mentioned below, the fourth threshold value is preferably set less than the second threshold value.

A second invention comprises a FET, a control circuit, a drain-source voltage detecting circuit, a drain-source voltage detection starting circuit and a first overcurrent protection signal generating circuit.

The drain-source voltage detecting circuit detects a drain-source voltage by comparing the magnitude of the drain-source voltage with a threshold value. A configuration of "detecting a drain-source voltage by comparing a magnitude of a drain-source voltage with a threshold value" is typically realized by specifying a region of the magnitude of the drain-source voltage by comparing the magnitude of the drain-source voltage with the threshold value.

Further, the drain-source voltage detecting circuit is configured such that the threshold value varies according to an electrical potential of an electrode of the FET connected to the DC power source. The term "an electrode of a FET connected to a DC power source" means "one of main electrodes (drain, source) of a FET which is connected to a DC power source (positive electrode of the DC power source)". And, the word "according to" or "corresponding to" means "proportional to" or "nearly proportional to".

When a ground fault occurred at a point between the FET and the load, a current (ground current or ground fault current) flowing through the FET increases rapidly at the beginning, then increases slowly, and then saturates. The larger the current in a saturated state (current reaching value) is, the larger the increasing rate of the current is.

If the threshold value is set to vary according to the electrical potential of the electrode of the FET connected to the DC power source, a resistance (ground resistance or ground fault resistance) between the FET and the ground which causes the drain-source voltage to be equal to the threshold value at the drain current saturated state can be specified. And, the relation between the threshold value and the electrical potential of the electrode of the FET connected to the DC power source is set such that the magnitude of the drain-source voltage is equal to the threshold value at a saturated state of a current flowing through a resistance between the FET and the ground which is equal to the upper limit within a resistance range corresponding to a current range in which a current is determined as the overcurrent, and the magnitude of the drain-source voltage is larger than the threshold value at a saturated state of a current flowing through the resistance between the FET and the ground which is smaller than the upper limit within the resistance range.

Thereby, the higher the current reaching value is (the larger the increasing rate of the drain-source voltage is), the earlier the first overcurrent protection signal is output from the first overcurrent protection signal generating circuit (overcurrent protecting operation is performed). Namely, the second overcurrent protection signal generating circuit for outputting the second overcurrent protection signal used in the first invention is not necessary.

When a channel temperature of the FET varies, an on-resistance of the FET varies and thereby the resistance between the FET and the ground, which causes the drain-source voltage to be equal to the threshold value in the current saturated state, varies. Therefore, it is preferable to configure such that the relation between the threshold value and the electrical potential of the electrode of the FET connected to the DC power source does not vary, even if the channel temperature of the FET varies. For example, the relation between the threshold value and the electrical potential of the electrode of the FET is set by using the on-resistance at an arbitrary operating ambient temperature in the vicinity of the FET and then the relation is corrected based on the variation of the on-resistance due to the variation of the operating ambient temperature in the vicinity of the FET.

The second invention has a feature that the resistance between the FET and the ground which causes the overcurrent is detected directly by using the threshold value, and can surely protect the FET against the overcurrent as well as the first invention. Therefore, even if electric power is supplied from a high voltage DC power source, such as a 500V DC power source, to a load, a FET can be used as a power switching element. Especially, a circuit configuration can be simplified since the second invention can perform the overcurrent protecting operation based on the drain-source voltage and the increasing rate of the drain-source voltage by using only the first overcurrent protection signal generating circuit.

In a modification of the first or the second invention, the first overcurrent protection signal generating circuit has a timer which outputs a timer signal during a predetermined timer period when the drain-source voltage becomes larger than a first threshold value. And, when the drain-source voltage continues for a predetermined period to be larger than a second threshold value which is larger than the first threshold value ([second threshold value > first threshold value]) (major overcurrent), the first overcurrent protection signal is output. Also, when the number of the timer signals output from the timer reaches a predetermined number (minor overcurrent), the first overcurrent protection signal is output. The term "larger" may include "equal".

This modification can securely perform the overcurrent protecting operation when either a major overcurrent or a minor overcurrent flows.

In a different modification of the first or the second inventions, the drain-source voltage detecting circuit has a first source follower circuit including a first P type MOSFET, a second source follower circuit including a second P type MOSFET, a threshold value setting circuit and a comparator.

A source of the first P type MOSFET is connected via a first resistor to an electrode of the FET connected to the load and a common gate bias potential is applied to a gate of the first P type MOSFET. The term "an electrode of a FET connected to a load" means "one of main electrodes (drain, source) of a FET which is connected to a load (negative electrode of the DC power source)".

A source of the second P type MOSFET is connected via a second resistor having a resistance equal to a resistance of the first resistor to an electrode of the FET connected to the DC power source and the common gate potential is applied to a gate of the second P type MOSFET. The second source follower circuit is configured such that a drain current of the second P type MOSFET has a magnitude corresponding to a voltage which is derived by subtracting the threshold value used at that time from the drain-source voltage.

The threshold value setting circuit is configured to be able to vary the drain current of the second P type MOSFET by drawing a current, which varies according to an electrical potential of the electrode of the FET connected to the DC power source, from the source of the second P type MOSFET.

The comparator detects whether or not the drain current of the second P type MOSFET is larger than that of the first P type MOSFET.

This modification can detect the drain-source voltage considering the increasing rate of the drain-source voltage. By incorporating the drain-source voltage detecting circuit of this embodiment into the second invention, a preferred effect can be obtained.

In a different modification of the first or the second inventions, an N type MOSFET is used as the FET. And, the drain-source voltage detection starting circuit starts the drain-source voltage detecting operation of the drain-source voltage detecting circuit when a gate potential of the N type MOSFET becomes larger than the drain potential of this MOSFET.

Or a P type MOSFET is used as the FET. And, the drain-source voltage detection starting circuit starts the drain-source voltage detecting operation of the drain-source voltage detecting circuit when a gate potential of the P type MOSFET becomes smaller than a drain potential of this MOSFET.

This modification can configure the overcurrent protection power supply apparatus by using a MOSFET as the power switching element.

In a different modification of the first or the second inventions, a constant voltage circuit keeps a magnitude of a voltage, which is applied to the drain-source voltage detecting circuit and the drain-source voltage detection starting circuit, at a constant value smaller than a magnitude of a voltage of the DC power source.

This modification can use FETs rated for low voltage system even if a high voltage DC power source supplies electric power to the load. Thereby, a chip area for the FETs can be prevented from increasing when integrating a circuit.

EFFECT OF THE INVENTION

The overcurrent protection power supply apparatus of this invention can supply electric power from a high voltage DC power source to a load by using a FET.

BRIEF DESCRIPTION OF THE DRAWINGS

Fig. 1 is a circuit diagram showing a first embodiment of the present invention.
Fig. 2 is a circuit diagram showing a second embodiment of the present invention.
Fig. 3 is a circuit diagram showing a third embodiment of the present invention.
Fig. 4 is a circuit diagram showing a fourth embodiment of the present invention.
Fig. 5 is a circuit diagram showing a prior art.
Fig. 6 is a chart showing $V_{DS}$ curves
Fig. 7 is a chart showing a ratio of $V_{DS}$ reaching times.
Fig. 8 is a circuit diagram showing a fifth embodiment of the present invention.
Fig. 9 is a chart showing a relation between a rush current or an overcurrent and a threshold value.

DETAILED DESCRIPTION OF THE PREFFERED EMBODIMENTS

At first, basic concepts of the overcurrent protection power supply apparatus of the present invention are discussed.

The present invention detects a current flowing through a FET used as a power switching element by detecting a drain-source voltage $V_{DS}$ which is generated between a drain and a source of the FET by a drain current $I_D$ flowing through the drain of the FET and a resistance $R_{ON}$ between the drain and the source of the FET ($V_{DS} = I_D \times R_{ON}$). And, the present invention turns off the FET to perform overcurrent protecting operation, when the drain-source voltage $V_{DS}$ becomes larger than a threshold value.

But, when a ground fault (dead short) occurs, the current (ground current or ground-fault current) through the FET rapidly reaches extraordinary large magnitude. In this case, if the overcurrent protecting operation is started after the drain-source voltage $V_{DS}$ becomes larger than the threshold value, sufficient overcurrent protection may not be provided.

The inventor of this invention has found that when the ground fault occurs, an increasing rate (incremental gradient) of the drain-source voltage $V_{DS}$ becomes large before the current (ground current) becomes large. That is, if the overcurrent protecting operation is started when it is detected that the increasing rate of the drain-source voltage $V_{DS}$ of the FET becomes large, the overcurrent protection can be quickly provided.

Thus, the overcurrent protection power supply apparatus of the present invention turns off the FET to provide the overcurrent protection when the increasing rate (incremental gradient) of the drain-source voltage $V_{DS}$ of the FET used as the power switching element becomes large as well as when the drain-source voltage $V_{DS}$ of the FET becomes large.

Embodiments of the present invention will now be described in detail with reference to the drawings.

First to fourth embodiments described below belong to a first type of the overcurrent protection power supply apparatus of the present invention and fifth embodiment belongs to a second type of the overcurrent protection power supply apparatus of the present invention.

The first type provides overcurrent protection by detecting either that the drain-source voltage $V_{DS}$ of the FET becomes large based on a magnitude of the drain-source voltage $V_{DS}$ or that the increasing rate of the drain-source voltage $V_{DS}$ of the FET becomes large based on the increasing rate of the magnitude of the drain-source voltage $V_{DS}$.

The second type provides overcurrent protection by detecting either that the drain-source voltage $V_{DS}$ of the FET becomes large or that the increasing rate of the drain-source voltage $V_{DS}$ of the FET becomes large based only on the magnitude of the drain-source voltage $V_{DS}$.

In the following description, unless otherwise noted, the term "voltage" means "magnitude (value) of the voltage" and the term "current" means "magnitude (value) of the current".

[First embodiment]

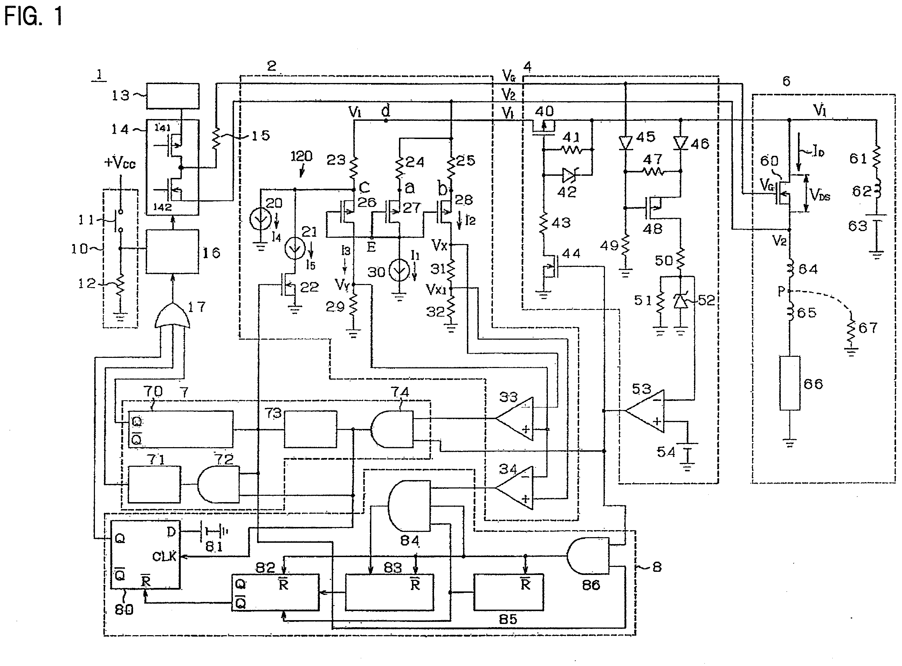

Fig. 1 is a circuit diagram showing a first embodiment of this invention. The overcurrent protection power supply apparatus of the first embodiment 1 comprises a drain-source voltage detecting circuit 2, a drain-source voltage detection starting circuit 4, an electric power supply circuit 6, a first overcurrent protection signal generating circuit 7, a second overcurrent protection signal generating circuit 8, a switch circuit 10, a charge pump circuit 13, a drive circuit 14, a control circuit 16 and an OR circuit 17.

(1) Electric power supply circuit 6

The electric power supply circuit 6 supplies electric power to a load 66 and has a DC power source 63 and an N type MOSFET 60 (hereinafter referred to as the "FET 60") used as a power switching element. A resistance symbol 61 and inductance symbols 62, 64 and 65 represent resistance and inductances respectively which are pertained to a wire.

A point P on a wire which connects the FET 60 with the load 66 represents an example of a place where a ground fault (dead short) occurred. When the ground fault occurs, a current (ground current) flows from the DC power source 63 to the ground via the FET 60 and a ground resistor (ground fault resistor) 67. Since the ground resistor 67 is very small, the ground current becomes very large.

The switch circuit 10 has a switch 11 and a resistor 12 which are connected in series between a voltage source Vcc and the ground (earth).

The driver circuit 14 has a P type MOSFET 141 (hereinafter referred to as the "FET 141") and an N type MOSFET 142 (hereinafter referred to as the "FET 142") of which drains are connected to each other. A voltage from the charge pump circuit 13 is applied to a source of the FET 141. The drain of the FET 141 is connected to a gate of the FET 60 of the electric power supply circuit 6 via a wire having a resistor 15. The wire connected to the gate of the FET 60 is called "$V_G$ line". A source of the FET 142 is connected to a source of the FET 60. A wire connected to the source of the FET 60 is called "$V_2$ line".

When the switch 11 is turned on, a voltage $V_{CC}$ at a point where the switch 11 and the resistor 12 are connected to each other is input to the control circuit 16 as a signal indicating a start of supplying electric power (power activation) to the load 66. When the switch 11 is turned on, the control circuit 16 turns on the FET 141 of the drive circuit 14 and turns off the FET 142 simultaneously, so that the voltage from the charge pump circuit 13 is supplied to the gate of the FET 60 via the resistor 15. Thereby, the FET 60 turns on, so that the power supply from the DC power source 63 to the load 66 is started.

(2) Drain-source voltage detection starting circuit 4

Let $R_{ON}$ represent an on-resistance of the FET 60, $I_D$ represent the drain current of the FET 60 and $V_{DS}$ represent the drain-source voltage of the FET 60.

When the FET 60 operates in an ohmic region, the equation (1) is established.

$$I_D \times R_{ON} = V_{DS} \qquad (1)$$

Since $I_D$ is proportional to $V_{DS}$ in a region where $R_{ON}$ is constant, $I_D$ can be known by detecting $V_{DS}$ and an increasing rate of $I_D$ can be known by detecting an increasing rate of $V_{DS}$.

$R_{ON}$ is constant when the FET 60 is in on-state and stable. Thus, in this state, an occurrence of a ground fault can be detected by evaluating the increasing rate of $I_D$ based on the increasing rate of $V_{DS}$.

However, during a transient period (about 1 micro second ($\mu$s)) when the FET 60 shifts from off-state to on-state after the switch 11 is turned on, the FET 60 operates in a pinch-off region. Therefore, during this transient period the equation (1) cannot be established. Namely, the increasing rate of $I_D$ cannot be detected precisely based on the increasing rate of $V_{DS}$. If it is configured that the FET 60 turns off based on the increasing rate of $V_{DS}$ in this transient period, the FET 60 may turn off incorrectly in a normal state.

When the FET 60 shifts from off-state to on-state, the drain-source voltage $V_{DS}$ of the FET 60 decreases rapidly at first and then turns to increase.

In order to prevent such a malfunction, start timing of detecting $V_{DS}$ can be delayed when the FET 60 turns on. However, if the start timing is delayed too long, enough overcurrent protection may not be provided when the ground fault occurred before the FET 60 turns on. For example, if a voltage of the DC power source 63 is 500V, the increasing rate of $I_D$ (ground current) reaches about 150A/micro second ($\mu$s).

Therefore, in order to securely provide the overcurrent protection, it is necessary to start the detection of $V_{DS}$ as soon as possible considering the transient period when the equation (1) cannot be established.

$V_1$, $V_G$ and $V_2$ are defined as follows.

$V_1$ ▪ ▪ ▪ Voltage of one of main electrodes (drain in Fig. 1) of the FET 60 which is connected to the DC power source 63 (positive electrode of the DC power source 63). $V_1$ is hereinafter referred to as "drain voltage $V_1$".
$V_G$ ▪ ▪ ▪ Voltage of the gate of the FET 60. $V_G$ is hereinafter referred to as "gate voltage $V_G$".
$V_2$ ▪ ▪ ▪ Voltage of another main electrode (source in Fig. 1) of the FET 60 which is connected the load 66 (negative electrode of the DC power source 63 via the load 66). $V_2$ is hereinafter referred to as "source voltage $V_2$".

The relation between $V_{DS}$, V1 and $V_G$ is represented by the equation [$V_{DS} = V_1 - V_2$].

In this embodiment, the voltage of the charge pump circuit 13 is set to [$V_1 + 15V$].

$V_G$ (= $V_2$) is negligible small compared with $V_1$ during the off-state of the FET 60. When the switch 11 is turned on, the voltage from the charge pump circuit 13 is applied to the gate of the FET 60, and thereby $V_G$ increases. Namely, at the time of power supply, the gate voltage $V_G$ of the FET 60 increases from a lower voltage than the drain voltage $V_1$, then exceeds the drain voltage $V_1$, and eventually reaches [$V_1 + 15V$].

At the time just after the gate voltage $V_G$ becomes larger than the drain voltage $V_1$ [$V_G > V_1$], states of the on-resistance $R_{ON}$, the drain current $I_D$ and the drain-source voltage $V_{DS}$ of the FET 60 are as follows.

(State of $R_{ON}$)

Just after $V_G$ becomes larger than $V_1$ [$V_G > V_1$], the gate-source voltage ($V_G - V_2$) of the FET 60 is slightly larger than a threshold voltage (from 3 to 4V) of the FET 60. At this time, the on-resistance $R_{ON}$ is not stable, but is in a stage of decreasing towards a saturated value. It is necessary for ($V_G - V_2$) to be more than 10V in order that the on-resistance $R_{ON}$ reaches the saturated value. A decreasing rate of the on-resistance $R_{ON}$ is about -36% / micro second ($\mu$s).

At this stage, since the on-resistance $R_{ON}$ is not stable, the drain-source voltage $V_{DS}$ of the FET 60 is not proportional to the drain current $I_D$.

(State of $I_D$)

Just after $V_G$ becomes larger than $V_1$ ([$V_G > V_1$]), the drain current $I_D$ of the FET 60 does not reach a final reaching value (saturated value) yet, but is in a stage of increasing. The increasing rate of the drain current $I_D$ is about +166% / micros econd ($\mu$s). The increasing rate of the drain current $I_D$ becomes maximum immediately after $V_G$ becomes larger than $V_1$ [$V_G > V_1$].

(State of $V_{DS}$)

The drain-source voltage $V_{DS}$ is represented by [$V_{DS} = R_{ON} \times I_D$]. As mentioned above, just after $V_G$ becomes larger than $V_1$ ([$V_G > V_1$]), $R_{ON}$ is in the stage of decreasing and $I_D$ is in the stage of increasing with the increasing rate larger than the decreasing rate of $R_{ON}$. In this case, since the decreasing rate of $R_{ON}$ is cancelled by the increasing rate of $I_D$, $V_{DS}$ represented by a product of them ([$V_{DS} = R_{ON} \times I_D$]) is in the stage of increasing.

As mentioned above, the drain-source voltage $V_{DS}$ is definitely in a stage of increasing after $V_G$ becomes larger than $V_1$ ([$V_G > V_1$]).

Therefore, this embodiment comprises the drain-source voltage detection starting circuit 4, which is configured such that the drain-source voltage detecting operation starts at the time when the gate voltage $V_G$ of the FET 60 becomes larger than the drain voltage $V_1$ of the FET 60 ([$V_G > V_1$]) after turning on the FET 60. And, when the increasing rate of $V_{DS}$ becomes larger than a threshold value, overcurrent protecting operation is performed. The threshold value is set to be smaller than the increasing rate of $V_{DS}$ generated by flowing of an overcurrent which should be cut and to be larger than the increasing rate of $V_{DS}$ generated by flowing of a normal current.

Thus, in the transient period in which the FET 60 shifts from off-state to on-state, a delay time to start the overcurrent detection ($V_{DS}$ detection) can be reduced, and thereby the overcurrent protection can be securely provided.

A circuit configuration of the drain-source voltage detection starting circuit 4 is explained.

A drain of a P type MOSFET 40 (hereinafter referred to as the "FET 40") is connected to a point d of the drain-source voltage detecting circuit 2 and a source of the FET 40 is connected to one of main electrodes (drain) of the FET 60 connected to the positive electrode of the DC power source 63 via a wire. The wire connected to the source of the FET 40 is referred to as the "$V_1$ line". A gate of the FET 40 is connected to the source of the FET 40 via a parallel circuit in which a resistor 41 and a Zener diode 42 are connected in parallel and to the ground via a resistor 43 and an N type MOSFET 44 (hereinafter referred to as the "FET 44"). An anode of the Zener diode 42 is connected to the gate of the FET 40.

An anode of a diode 45 is connected to the $V_G$ line and a cathode of the diode 45 is connected to a gate of a P type MOSFET 48 (hereinafter referred to as the "FET 48") and to the ground via a resistor 49. An anode of a diode 46 is connected to the $V_1$ line and a cathode of the diode 46 is connected to a source of the FET 48. A cathode of the diode 45 and a cathode of the diode 46 are connected via a resistor 47.

A drain of the FET48 is connected to the ground via a resistor 50 and a parallel circuit in which a resistor 51 and a Zener diode 52 are connected in parallel and to an inverted input terminal of a comparator 53 via the resistor 50. A non-inverted input terminal of the comparator 53 is connected to a DC power source 54. An output terminal of the comparator 53 is connected to a gate of the FET 44, the first overcurrent protection signal generating circuit 7 and the second overcurrent protection signal generating circuit 8.

Operation of the drain-source voltage detection starting circuit 4 is explained.

([$V_G < V_1$] is satisfied.)

In this state, the diode 45 is inversely biased, so that a current flows through the diode 46, the resistors 47 and the resistor 49. Thereby, the FET 48 turns on, so that a Zener voltage generated between both ends of the Zener diode 52 is applied to the inverted input terminal of the comparator 53. Since the Zener voltage is set to be larger than a voltage of the DC power source 54, the output of the comparator 53 becomes L level (hereinafter referred to simply as "L"). Since the output of the comparator 53 is L, the FETs 44 and 40 are in off-state.

([$V_G > V_1$] is satisfied.)

In this state, the diode 45 is forward biased, so that a voltage $V_G$ from the $V_G$ line is applied to the gate of the FET 48. Thereby, the FET 48 turns off. When the FET 48 turns off, the voltage between both ends of the Zener diode 52 becomes zero, so that the output of the comparator 53 becomes H level (hereinafter referred to simply as "H").

When the output of the comparator 53 becomes H, both FETs 40 and 44 turn on. When the FET 40 turns on, the voltage $V_1$ from the $V_1$ line is applied to the point d of the drain-source voltage detecting circuit 2, and thereby the drain-source voltage detecting circuit 2 starts to operate.

(3) Drain-source voltage detecting circuit 2

The drain-source voltage detecting circuit 2 detects whether or not the drain-source voltage $V_{DS}$ of the FET 60 is larger than the threshold value. That is, the drain-source voltage detecting circuit 2 outputs a result of comparing $V_{DS}$ with the threshold value.

A circuit configuration of the drain-source voltage detecting circuit 2 is explained.

The $V_1$ line is connected to the ground via a resistor 23, a source and a drain of a P type MOSFET 26 (hereinafter referred to as the "FET 26") and a resistor 29. A connecting point c of the resistor 23 and the FET 26 is connected to the ground via a detecting voltage reducing circuit 120.

The detecting voltage reducing circuit 120 comprises a series circuit, in which a constant current source (constant current circuit) 21 providing a constant current $I_5$ and an N type MOSFET 22 (hereinafter referred to as the "FET22") are connected in series, and a constant current source (constant current circuit) 20 providing a constant current $I_4$ which is connected in parallel to the series circuit. A gate of the FET 22 is connected to the first overcurrent protection signal generating circuit 7.

A voltage $V_Y$ is generated between both ends of the resistor 29 by a current $I_3$ flowing through the FET 26. The voltage $V_Y$ varies according to the drain-source voltage $V_{DS}$ of the FET 60. Since the drain-source voltage $V_{DS}$ of the FET 60 varies according to the drain current $I_D$ of the FET 60, the voltage $V_Y$ varies according to the drain current $I_D$ of the FET 60. The voltage $V_Y$ is used as a detecting voltage corresponding to the drain-source voltage $V_{DS}$ of the FET 60.

In this embodiment, the drain of the FET 60 corresponds to "an electrode of a FET which is connected to a positive electrode of a DC power source" of the present invention. And the detecting voltage $V_Y$ corresponds to "a detecting signal (detecting voltage) corresponding to a drain-source voltage $V_{DS}$ of the FET" of the present invention. And, the "second source follower circuit" comprises the resistor 23, the FET 26 and the resistor 29. The "detecting signal generating circuit which generates a detecting signal corresponding to $V_{DS}$ of the FET" comprises the second source follower circuit and the detecting voltage reducing circuit 120.

The $V_2$ line is connected to the ground via a resistor 24, a source and a drain of a P type MOSFET 27 (hereinafter referred to as the "FET 27") and a constant current source 30 providing a constant current $I_1$. A gate of the FET 27 is connected to a drain of the FET 27.

The $V_2$ line is connected to the ground via a resistor 25, a source and a drain of a P type MOSFET 28 (hereinafter referred to as the "FET 28"), a resistor 31 and a resistor 32. A voltage $V_X$ generated between both ends of a series circuit, in which a resistors 31 and 32 are connected in series, by a current $I_2$ flowing through the FET 28 and a voltage $V_{X1}$ generated between both ends of the resistor 32 are used as reference voltages which are compared with the voltage $V_Y$.

In this embodiment, the source of the FET 60 corresponds to "another electrode of a FET which is connected to a load" of the present invention. The reference voltages $V_X$ and $V_{X1}$ correspond to "a reference signal (reference voltage)" of the present invention. "A first source follower circuit" comprises the resistor 25, the FET 28, the resistor 31 and the resistor 32. The first source follower circuit corresponds to "a reference signal generating circuit" of the present invention.

The FETs 26, 27 and 28 are P type MOSFETs having the same characteristics and each of the gates is connected to a common connecting point E.

Resistance $R_{29}$ of the resistor 29, resistance $R_{31}$ of the resistor 31 and resistance $R_{32}$ of the resistor 32 are set to satisfy the equation [$R_{29} = R_{31} + R_{32}$].

And, resistance $R_{23}$ of the resistor 23, resistance $R_{24}$ of the resistor 24 and resistance $R_{25}$ of the resistor 25 are set to satisfy the equation [$R_{23} = R_{24} = R_{25}$].

When a current is not drawn from the connecting point c toward the constant current sources 20 and 21 ($I_4$ = 0, $I_5$ = 0) and [$V_Y = V_X$] is satisfied, [$I_2 = I_3$] is satisfied since resistances $R_{29}$, $R_{31}$ and $R_{32}$ are set to satisfy the equation [$R_{29} = R_{31} + R_{32}$]. Furthermore, since the FETs 26 and 28 have the same characteristic, both gate potentials $V_E$ are the same and resistances $R_{23}$ and $R_{25}$ are set to satisfy the equation [$R_{23} = R_{25}$], [$V_1 = V_2$] is satisfied. Namely, the drain-source voltage $V_{DS}$ of the FET 60 is zero ([$V_{DS}$ = 0]).

When a current is drawn from the connecting point c toward the constant current sources 20 and 21 ($I_4 \neq 0$, $I_5 \neq 0$) and [$V_Y = V_X$] is satisfied, [$V_1 > V_2$] is satisfied. Namely, $V_{DS}$ is not zero but a positive value.

When the current drawn from the connecting point c is increased by the detecting voltage reducing circuit 120, the current $I_3$ decreases, and thereby the detecting voltage $V_Y$ also decreases. Namely, the detecting voltage $V_Y$ decreases by an increase of the current drawn. In other words, the reference voltages $V_X$ and $V_{X1}$ increase relatively by the increase of the current drawn.

A comparator 33 compares the detecting voltage $V_Y$ with the reference voltage (reference signal) $V_X$. $V_X$ is applied to the inverted input terminal of the comparator 33 and $V_Y$ is applied to the non-inverted input terminal. The output terminal of the comparator 33 is connected to the first overcurrent protection signal generating circuit 7 (AND circuit 74). The output of the comparator 33 is L when [$V_Y < V_X$] is satisfied, and H when [$V_Y > V_X$] is satisfied.

A comparator 34 compares the detecting voltage $V_Y$ with the reference voltage (reference signal) $V_{X1}$. $V_Y$ is applied to an inverted input terminal of the comparator 34 and $V_{X1}$ is applied to a non-inverted input terminal. An output terminal of the comparator 34 is connected to the second overcurrent protection signal generating circuit 8 (AND circuit 84). The output of the comparator 34 is H when $[V_Y < V_{X1}]$ is satisfied, and L when $[V_Y > V_{X1}]$ is satisfied.

Operation of the drain-source voltage detecting circuit 2 is explained.

($[V_G < V_1]$ is satisfied, while the FET 40 is in off-state.)

When the FET 60 turns on, the source voltage $V_2$ increases, so that the current $I_2$ flows through the first source follower circuit. Thereby each of the reference voltages $V_X$ and $V_{X1}$ becomes a positive value.

On the other hand, since the FET 40 is in off-state, the drain voltage $V_1$ is not applied to the second source follower circuit, so that the current $I_3$ is zero. Thereby the detecting voltage $V_Y$ is zero.

In this state, $[V_X > V_Y]$ is satisfied, so that the output of the comparator 33 is L.

($[V_G > V_1]$ is satisfied, while the FET 40 is in on-state.)

When $[V_G > V_1]$ is satisfied due to an increase of the gate voltage $V_G$, the output of the comparator 53 becomes H, so that the FETs 44 and 40 turn on. Thereby, the drain voltage $V_1$ from the $V_1$ line is applied to the second source follower circuit, so that the current $I_3$ flows. The current $I_4$ is set such that while $V_{DS}$ is small, $V_Y$ is also small and $[V_X > V_Y]$ is satisfied. Thereby, while $V_{DS}$ is small, the output of the comparator 33 is L. When the output of the comparator 33 is L, the FET 22 is in off-state as described below.

($I_D$ is within a normal range and constantly flows, while the FET 22 is in off-state.)

When the drain current $I_D$ of the FET 60 is within a normal range and flows constantly, the output of the comparator 33 is L. While the output of the comparator 33 is L, the FET 22 is in off-state.

(The output of the comparator 33 is H, while the FET 22 is in off-state.)

When $[V_Y > V_X]$ is satisfied while the FET 22 is in off-state, the output of the comparator 33 is H. $V_{DSA}$ is defined as a magnitude of $V_{DS}$ at the time when the output of the comparator 33 becomes H and can be determined as follows. Let $V_a$, $V_b$ and $V_c$ represent voltages respectively at points a, b and c shown in Fig. 1.

$I_2$ is represented by the equation (2).

$$I_2 = (V_2 - V_b) / R_{25} \qquad (2).$$

Since equations $[R_{23} \times (I_3 + I_4) = V_1 - V_C]$ and $[V_1 = V_2 + V_{DS}]$ are established, $I_3$ is represented by the equation (3).

$$I_3 = (V_2 + V_{DS} - R_{23} \times I_4 - V_c) / R_{23} \qquad (3)$$

$V_X$ is represented by the equation (4).

$$V_X = (R_{31} + R_{32}) \times I_2 = (R_{31} + R_{32}) \times (V_2 - V_b) / R_{25} \qquad (4)$$

$V_Y$ is represented by the equation (5).

$$V_Y = R_{29} \times I_3 = R_{29} \times (V_2 + V_{DS} - R_{23} \times I_4 - V_c) / R_{23} \qquad (5)$$

$V_{DS}$ at the time when $V_Y$ becomes equal to $V_X$ ($[V_Y = V_X]$) is defined as $V_{DSA}$ which is a magnitude of $V_{DS}$ at the time when the output of the comparator 33 changes from L to H. So $V_{DSA}$ can be represented by the equation (6) derived from the equation (4) which represents $V_X$ and the equation (5) which represents $V_Y$.

$$V_{DSA} = R_{23} \times I_4 \qquad (6)$$

It is understood from the equation (4) that $V_X$ is independent of $V_{DS}$.

On the other hand, it is understood from the equation (5) that $V_Y$ varies according to $V_{DS}$. That is, when $V_{DS}$ is small, $V_Y$ is also small, so that $[V_Y < V_X]$ is satisfied. $V_Y$ increases with an increase of $V_{DS}$, then becomes equal to $V_X$ ($[V_Y = V_X]$), and then becomes larger than $V_X$ ($[V_Y > V_X]$). When $[V_Y > V_X]$ is satisfied, the output of the comparator 33 becomes H.

It is understood from the equation (6) that $V_{DSA}$, which is the magnitude of $V_{DS}$ at the time when the output of the comparator 33 becomes H while the FET 22 is in off-state, can be set arbitrarily by adjusting the current $I_4$ provided by the constant current source 20. Since the current $I_4$ provided by the constant current source 20 can be set precisely to a constant value, $V_{DSA}$ also can be set precisely to a constant value.

Although the details will be described later, the FET 22 turns on when the output of the comparator 33 becomes H.

(The FET 22 is in on-state.)

When the FET 22 turns on, the current $I_5$ flows, so that the sum of the currents $I_4$ and $I_5$ is drawn from the point c. Let $V_{DSB}$ represent a magnitude of $V_{DS}$ at the time when the output of the comparator 33 becomes H while the FET 22 is in on-state, $V_{DSB}$ is represented by the equation (7) derived from the equation (6) by replacing $I_4$ with $(I_4 + I_5)$.

$$V_{DSB} = R_{23} \times (I_4 + I_5) \qquad (7)$$

Since $(I_4 + I_5)$ can be set precisely to a constant value, $V_{DSB}$ also can be set precisely to a constant value.

Let $V_{DSC}$ represent a magnitude of $V_{DS}$ at the time when the output of the comparator 34 becomes L while the FET 22 is in on-state, $V_{DSC}$ can be determined as follows.

$V_{X1}$ is represented by the equation (8).

$$V_{X1} = R_{32} \times I_2 = R_{32} \times (V_2 - V_b) / R_{25} \qquad (8)$$

$V_Y$ is represented by the equation (9).

$$V_Y = R_{29} \times I_3 = R_{29} \times \{V_2 + V_{DSC} - R_{23} \times (I_4 + I_5) - V_C\} / R_{23} \qquad (9)$$

Since $V_{DS}$ at the time when $[V_{X1} = V_Y]$ is satisfied ($V_{X1}$ becomes equal to $V_Y$) is defined as $V_{DSC}$ which is the magnitude of $V_{DS}$ at the time when the output of the comparator 34 changes from H to L, $V_{DSC}$ is represented by the equation (10) derived from the equation (8) which represents Vxi and the equation (9) which represents $V_Y$.

$$V_{DSC} = (R_{32} - R_{29}) \times (V_2 - V_b) / R_{29} + R_{23} \times (I_4 + I_5) + (V_c - V_b) \qquad (10)$$

Since FETs 26 and 28 have the same threshold voltage $V_{th}$, let $R_{ON1}$ represent on-resistance of each of the FETs 26 and 28, $(V_c - V_b)$ is represented by the equation (11).

$$(V_c - V_b) = R_{ON1} \times \{V_{DSC} - R_{23} \times (I_4 + I_5)\} / (R_{ON1} + R_{25}) \qquad (11)$$

The equation (12) is derived by substituting the equation (11) into the equation (10).

$$V_{DSC} = \{(R_{32} - R_{29}) / R_{29}\} \times \{1 + (R_{ON1} / R_{25})\} \times (V_2 - V_b) + R_{23} (I_4 + I_5) \qquad (12)$$

Since the resistances $R_{29}$, $R_{31}$ and $R_{32}$ are set to satisfy the equation $[R_{31} + R_{32} = R_{29}]$ as mentioned above, $[R_{32} < R_{29}]$ is satisfied. Thus, the first term of the equation (12) is a negative value. The second term of the equation (12) is $V_{DSB}$ since the second term is the same as the right side of the equation (7). Namely, $V_{DSC}$ can be set to an arbitrary value by adjusting ($R_{32}$ - $R_{29}$).

Since $V_{DSC}$ is smaller than $V_{DSB}$ by the first term of the equation (12), [$V_{DSC} < V_{DSB}$] is satisfied. It can also be understood intuitively based on the circuit configuration that [$V_{DSC} < V_{DSB}$] is satisfied. That is, it can be understood immediately by viewing the circuit configuration that [$V_{X1} < V_X$] is satisfied. $V_{DS}$ at the time when $V_Y$ exceeds $V_{X1}$ is defined as $V_{DSC}$ and $V_{DS}$ at the time when $V_Y$ exceeds $V_X$ is defined as $V_{DSB}$. Thus, it can be understood immediately that [$V_{DSC} < V_{DSB}$] is satisfied.

Since the equation (12) includes $R_{ON1}$ which cannot be always constant, $V_{DSC}$ cannot be precisely set to a constant value.

$V_{DSA}$, $V_{DSB}$, and $V_{DSC}$ are summarized as follows.

The magnitudes of them are set to satisfy [$V_{DSA} < V_{DSC} < V_{DSB}$].

$V_{DSA}$ ▪ ▪ ▪ $V_{DS}$ at the time when the output of the comparator 33 becomes H while the FET 22 is in off-state.
$V_{DSB}$ ▪ ▪ ▪ $V_{DS}$ at the time when the output of the comparator 33 becomes H while the FET 22 is in on-state.
$V_{DSC}$ ▪ ▪ ▪ $V_{DS}$ at the time when the output of the comparator 34 becomes L while the FET 22 is in on-state.

Each of $V_{DSA}$, $V_{DSB}$ and $V_{DSC}$ corresponds to "a threshold value" of the present invention.

(4) First overcurrent detecting signal generating circuit 7

The first overcurrent detecting signal generating circuit 7 generates (outputs) an overcurrent protection signal (first overcurrent protection signal) when the drain-source voltage $V_{DS}$ of the FET 60 becomes larger than a threshold value (the detecting voltage becomes larger than the reference voltage).

Outputs of the comparators 53 and 33 are applied to the inputs of the AND circuit 74. An output of the AND circuit 74 is applied to a timer 73, an AND circuit 72 and a D type flip-flop 80 of the second overcurrent protection signal generating circuit 8.

An output of the timer 73 is applied to the AND circuit 72, a counter 70, the gate of the FET 22 of the drain-source voltage detecting circuit 2 and an AND circuit 86 of the second overcurrent protection signal generating circuit 8.

A non-inverted output Q of the counter 70 is applied to the OR circuit 17. An output of the AND circuit 72 is applied to the OR circuit 17 via a digital filter 71.

The first overcurrent protection signal generating circuit 7 operates as follows.

(Normal current)

When the FET 60 turns on and [$V_G > V_1$] is satisfied, the output of the comparator 53 becomes H, so that the FETs 40 and 44 turn on. When the FET 40 turns on, the drain voltage $V_1$ of the FET 60 is applied to the point d and then $I_3$ flows. And $V_Y$ is generated by flowing of $I_3$.

When $I_D$ is in a normal state (the magnitude of $I_D$ is within a normal range), $V_{DS}$ of the FET 60 is small, so that $V_Y$ is smaller than $V_X$ ([$V_X > V_Y$]) and the output of the comparator 33 is L. Thereby the output of the AND circuit 74 and the output of the timer 73 are L. In this state, the FET 22 is in off-state. This state is referred to as the "I-mode".

(Overcurrent)

When [$V_X < V_Y$] is satisfied due to an increase of $I_D$ ($V_{DS}$), the output of the comparator 33 becomes H, so that the output of the AND circuit 74 becomes H because both inputs of the AND circuit 74 (outputs of the comparators 33 and 53) becomes H.

When the output of the AND circuit 74 becomes H, the output of the timer 73 is maintained at H during the timer period $T_S$. If the output of the AND circuit 74 does not become H again within the timer period $T_S$, the output of the timer 73 returns to L.

When the output of the timer 73 becomes H, the FET 22 turns on and thereby $I_5$ flows. This state is referred to as the "T-mode".

When $I_5$ starts to flow, the current drawn from the point c increases and $I_3$ decreases by $I_5$. So the detecting voltage $V_Y$ is reduced (decreased) according to the decrease of $I_3$. In other words, the reference voltage $V_X$ is pulled up (increased). And, [$V_X > V_Y$] is satisfied after the decrease of $V_Y$ (increase of $V_X$), so that the output of the comparator 33 returns to L.

(Minor overcurrent)

When an operation mode enters the T-mode due to the flow of the overcurrent ([$V_X < V_Y$]), $V_Y$ decreases with

the decrease of $I_3$, so that $[V_Y < V_X]$ is satisfied. If the overcurrent is not so large that $V_Y$ does not increase to satisfy $[V_X < V_Y]$ after entering the T-mode, namely, a minor overcurrent flows, the state in which $[V_X > V_Y]$ is satisfied is maintained during the timer period $T_S$. Then, the output of the timer 73 returns to L, so that the FET 22 turns off. When the FET 22 turns off, $I_5$ becomes zero, and thereby reducing of $V_Y$ (pulling up of $V_X$) is stopped. That is, the mode returns to the I-mode.

When $[V_Y > V_X]$ is satisfied in the I-mode, the T-mode occurs again. While the minor overcurrent continues to flow, the I-mode and the T-mode are exchanged repeatedly.

If the number of times of exchange is small (for example, 1 or 2 times), it is not necessary to perform overcurrent protecting operation. But, if the number of times of exchange is large, it is necessary to perform overcurrent protecting operation. So, the counter 70 is provided.

The counter 70 counts up a count value whenever the output of the timer 73 becomes H (the T-mode occurs).

When the count value (count number) of the counter 70 reaches a predetermined value (predetermined number) N, an output terminal Q of the counter 70 becomes H. The output H from the output terminal Q of the counter 70 is applied to the control circuit 16 via the OR circuit 17. The control circuit 16 turns off the FET 60 to perform overcurrent protecting operation when the output of the OR circuit 17 becomes H. The output terminal Q of the counter 70 becomes H only when the count value counted up within a predetermined period reaches N.

The output H from the output terminal Q of the counter 70 corresponds to "a first overcurrent protection signal" of the present invention.

When the minor overcurrent is detected to result in N times continuously by repeating the timer period $T_S$, the FET 60 turns off after the lapse of a period $[T_S \times N]$. The period $[T_S \times N]$ is preferred to be shorter than 1 second.

As mentioned above, when the number of detections of the minor overcurrent reaches the predetermined number N, the FET 60 is turned off, and thereby overcurrent protecting operation is performed.

(Major overcurrent)

When a major overcurrent flows, $V_{DS}$ continues to increase after entering the T-mode, so that the reduced detecting voltage $V_Y$ turns to increase immediately. Then, $V_{DS}$ (reduced $V_{DS}$) reaches $V_{DSB}$ and $[V_X < V_Y]$ is satisfied before the lapse of the timer period $T_S$ of the timer 73, so that the output of the comparator 33 becomes H. Thereby, the output of the AND circuit 74 becomes H. At the time when the output of the AND circuit 74 becomes H, the output of the timer 73 is maintained at H since the timer period $T_S$ of the timer 73 does not elapse. Thereby an output of an AND circuit 72 becomes H.

Output H from the AND circuit 72 is applied to a digital filter 71. When the output of the AND circuit 72 is maintained at H for a predetermined period, an output of the digital filter 71 becomes H. Output H from the digital filter 71 is applied to the control circuit 16 via the OR circuit 17. The control circuit 16 turns off the FET 60 to perform overcurrent protecting operation when the output of the OR circuit 17 becomes H.

The digital filer 71 prevents the FET 60 from turning off when the output of the AND circuit 72 becomes H for a short time due to high frequency noises, that is, from malfunctioning due to high frequency noises..

(5) Second overcurrent protection signal generating circuit 8

The second overcurrent protection signal generating circuit 8 generates an overcurrent protection signal (second overcurrent protection signal) when an increasing rate of the drain-source voltage $V_{DS}$ becomes larger than a threshold value.

The AND circuit 86 receives the output of the comparator 53 of the drain-source voltage detection starting circuit 4 and the output of the timer 73 of the first overcurrent protection signal generating circuit 7. When the output of the timer 73 is L ("I mode"), an output of the AND circuit 86 is L, so that a clock circuit 85 and counters 82 and 83 are reset. Namely, the second overcurrent protection signal generating circuit 8 operates when the output of the timer 73 is H ("T mode").

An AND circuit 84 receives the outputs of the comparator 34, the AND circuit 86 and the clock circuit 85. An output of the AND circuit 84 is applied to an input terminal of the counter 83. The output of the clock circuit 85 is also applied to an input terminal of the counter 82.

An output of the counter 83 is applied to a set input terminal of the counter 82. An inverted output terminal Q-bar of the counter 82 is connected to a reset terminal R-bar of a the D type flip-flop 80. An output from a non-inverted output terminal Q of the D type flip-flop 80 is applied to the control circuit 16 via the OR circuit 17.

The counter 83 counts up a clock signal input from the AND circuit 84. And when the input of the clock signal is stopped, the counter 83 outputs a count value (count number) $N_{83}$ (hereinafter, referred to as the "first count value") which the counter 83 counts up theretofore.

The counter 82 calculates a time $T_{82}$ according to the equation (13) by using the first count value $N_{83}$ input from the counter 83 and sets $T_{82}$ as an increasing rate detecting time.

$$T_{82} = K \times N_{83} \times T_C + \alpha \qquad (13)$$

K denotes a constant, $T_C$ denotes a period of the clock signal (clock period) output from the clock circuit 85. $\alpha$ denotes a constant and $(N_{83} \times T_C)$ is equal to a time $T_{83}$ which is required for the counter 83 to reach $N_{83}$.

The increasing rate detecting time $T_{82}$ corresponds to "a reference time" of the present invention.

The inverted output terminal Q-bar of the counter 82 maintains H until the increasing rate detecting time $T_{82}$ has elapsed since the counter 82 started to count, and becomes L after the increasing rate detecting time $T_{82}$ has elapsed.

When a signal applied to a clock terminal CLK of the D type flip-flop 80 changes from L to H while the reset terminal R-bar receives H (within the increasing rate detecting time $T_{82}$), the non-inverted output terminal Q of the D type flip-flop 80 becomes H. The output H of the non-inverted output terminal Q is applied to the control circuit 16 via the OR circuit 17.

After the reset terminal R-bar of the D type flip-flop 80 receives L (after the lapse of the increasing rate detecting time $T_{82}$), the non-inverted output terminal Q of the D type flip-flop 80 never becomes H even if the signal applied to the clock terminal CLK changes from L to H.

First, the increasing rate of $V_{DS}$ is explained.

An overcurrent I is represented by the equation (14) expressing an exponential waveform.

$$I = (V_B / R) \times \{1 - \exp(-R \times t / L)\} \qquad (14)$$

$V_B$ denotes a power supply voltage. R denotes a resistance of a current path (a whole current path via which the overcurrent flows). L denotes an inductance of the current path (the whole current path via which the overcurrent flows). (L / R) denotes a time constant. $(V_B / R)$ denotes a reaching value of the overcurrent. "t" denotes a time.

Assuming that when the overcurrent flows through the electric power supply circuit 6 shown in Fig. 1, an ambient temperature in the vicinity of the FET 60 reaches 125 degrees Celsius (°C) which is an upper temperature limit and $R_{ON125}$ represents the on-resistance of the FET 60 at that time, $V_{DS}$ is represented by the equation (15).

$$V_{DS} = R_{ON125} \times (V_B / R) \{1 - \exp(-R \times t / L)\} \qquad (15)$$

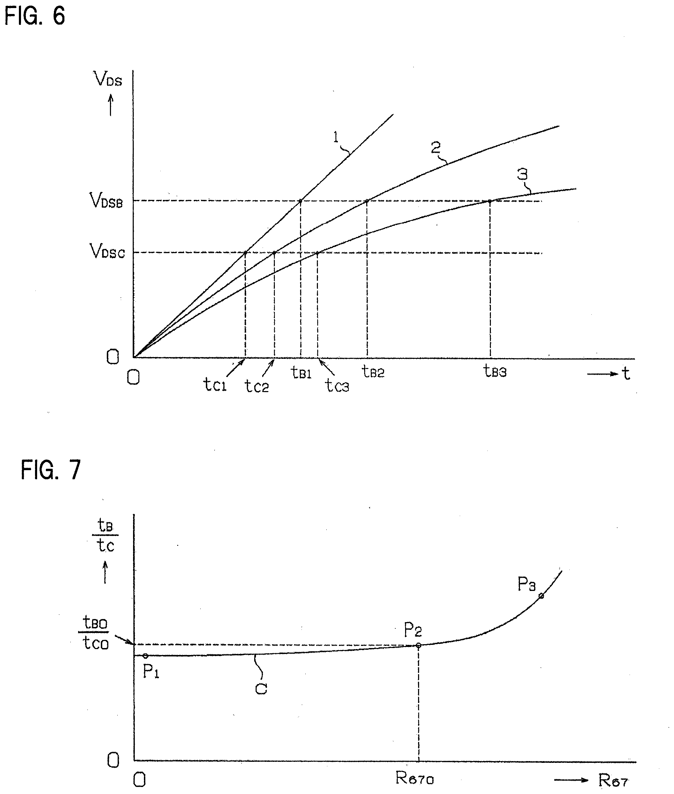

Fig. 6 is a chart showing $V_{DS}$ curves. In Fig. 6, the horizontal axis denotes time and the vertical axis denotes $V_{DS}$. Numerals 1, 2 and 3 shown in Fig. 6 indicate three $V_{DS}$ curves. $V_{DS}$ is obtained by multiplying the overcurrent I, which flows from the point P to the ground via the ground resistor 67, by the on-resistance $R_{ON125}$ of the FET 60. The curves 1, 2 and 3 represent $V_{DS}$s respectively obtained by using different ground resistance. Each overcurrent used to obtain the curves 1, 2 and 3 flows through the same current path except for the ground resistance.

The curve 1 represents $V_{DS}$ obtained by using the smallest ground resistance and the curve 3 represents $V_{DS}$ obtained by using the largest ground resistance. It is understood from Fig. 6 that the smaller the ground resistance is, the more rapidly $V_{DS}$ curve rises.

$t_C$ ($t_{C1}$, $t_{C2}$, $t_{C3}$) and $t_B$ ($t_{B1}$, $t_{B2}$, $t_{B3}$) are times for the curves 1, 2 and 3 to reach threshold values $V_{DSC}$ and $V_{DSB}$ respectively.

Let t equal to $t_C$ [t = $t_C$] and $V_{DS}$ equal to $V_{DSC}$ [$V_{DS} = V_{DSC}$], the equation (15) is represented by the equation (16).

$$V_{DSC} = R_{ON125} \times (V_B / R) \{1 - \exp(-R \times t_C / L)\} \qquad (16)$$

$t_C$ is represented by the equation (17) derived from the equation (16).

$$t_C = -(L / R) \times \ln\{1 - R \times V_{DSC} / (R_{ON125} \times V_B)\} \qquad (17)$$

Similarly, when let $V_{DS}$ equal to $V_{DSB}$ [$V_{DS} = V_{DSB}$], $t_B$ is represented by the equation (18).

$$t_B = -(L / R) \times \ln\{1 - R \times V_{DSB} / (R_{ON125} \times V_B)\} \qquad (18)$$

($t_B / t_C$) is represented by the equation (19) derived from the equations (17) and (18). ($t_B / t_C$) is the ratio of the time $t_B$ for $V_{DS}$ to reach the threshold value $V_{DSB}$ to the time $t_C$ for $V_{DS}$ to reach the threshold value $V_{DSC}$, so $(t_B / t_C)$ is referred to as the "a ratio of $V_{DS}$ reaching times".

$$(t_B / t_C) = \ln \{1 - R \times V_{DSB} / (R_{ON125} \times V_B)\} / \ln \{1 - R \times V_{DSC} / (R_{ON125} \times V_B)\} \qquad (19)$$

The voltage $V_B$ of the DC power source 63 of the electric power supply circuit 6 and $R_{ON125}$ of the FET 60 are fixed, and the threshold values $V_{DSC}$ and $V_{DSB}$ are set arbitrary. Thus, it is understood from the equation (19) that $(t_B / t_C)$ is a function only of the resistance R of the current path, but does not depend on the inductance L of the current path.

The resistance R of the current path is the sum of a circuit resistance between the DC power source 63 and the ground fault point P and the ground resistance $R_{67}$ caused by the ground fault. When the ground fault occurs at the same point P, each resistance between the DC power source 63 and the ground fault point is identical. Thus, $(t_B / t_C)$ is a function only of the ground resistance $R_{67}$.

Fig. 7 is a chart showing a ratio of $V_{DS}$ reaching times. In Fig. 7, the horizontal axis denotes the ground resistance $R_{67}$ and the vertical axis denotes the ratio of $V_{DS}$ reaching times $(t_B / t_C)$. Points $P_1$, $P_2$ and $P_3$ on a curve C of the ratio of $V_{DS}$ reaching times indicate respectively the ratio of $V_{DS}$ reaching times $(t_B / t_C)$ of the $V_{DS}$ curves 1, 2 and 3 shown in Fig. 6. For example, the ratio of $V_{DS}$ reaching time $(t_B / t_C)$ at the point P1 is $(t_{B1} / t_{C1})$.

It is understood from Fig. 7 that the smaller the ground resistance $R_{67}$ is, the smaller $(t_B / t_C)$ is. On the other hand, it is understood from Fig. 6 that the smaller the ground resistance $R_{67}$ is, the larger the value (current reaching value) which the overcurrent reaches and the increasing rate of the overcurrent are. Namely, when the overcurrent flows through the identical path, the smaller the ground resistance $R_{67}$ is or the larger the increasing rate of $V_{DS}$ is, the smaller the ratio of $V_{DS}$ reaching time $(t_B / t_C)$ is. Thus, it is understood that the severity (current reaching value and increasing rate) of the overcurrent can be determined based on the ratio of $V_{DS}$ reaching times $(t_B / t_C)$.

When the FET 60 turns on, a rush current flows through a current path. This rush current increases exponentially such as the ground fault current. It must be configured to prevent the FET 60 from being turned off (shut down) when the rush current flows. So, a current reaching value larger than the current reaching value which the rush current reaches is selected. And, a ratio of $V_{DS}$ reaching time $(t_B / t_C)$ obtained from an overcurrent which reaches the selected current reaching value is set as a threshold value $(t_{B0} / t_{C0})$ for overcurrent protection. Thereby, the FET 60 can be prevented from being turned off (shut down) incorrectly when the rush current flows.

Let $R_0$ represent resistance R of a current path (ground resistance $R_{670}$) which is used when the threshold value $(t_{B0} / t_{C0})$ is set, the threshold value $(t_{B0} / t_{C0})$ is represented by the equation (20).

$$(t_{B0} / t_{C0}) = \ln \{1 - R_0 \times V_{DSB} / (R_{ON125} \times V_B)\} / \ln \{1 - R_0 \times V_{DSC} / (R_{ON125} \times V_B)\}$$

$$(20)$$

In Fig. 7, the point $P_2$, namely, $(t_{B2} / t_{C2})$ of the curve 2 shown in Fig. 6 is set as the threshold value $(t_{B0} / t_{C0})$.

In this case, when $(t_B / t_C)$ is smaller than $(t_{B0} / t_{C0})$ $([(t_B / t_C) < (t_{B0} / t_{C0})])$, for example, at the point P1, overcurrent protection is provided. But, when $(t_B / t_C)$ is larger than $(t_{B0} / t_{C0})$, for example, at the point P3, overcurrent protection is not provided.

In the above, it is premised that the FET 60 operates at the upper temperature limit 125 degrees Celsius (°C) of the ambient temperature. However, when the FET 60 operates at an ambient temperature lower than the upper temperature limit 125 degrees Celsius (°C), the on-resistance $R_{ON}$ of the FET 60 at that ambient temperature is smaller than $R_{ON125}$. If $R_0$ is identical, a threshold value $(t_{B0} / t_{C0})$ which is derived from the equation (20) by replacing $R_{ON125}$ with $R_{ON}$ is larger than a threshold value which is derived by using $R_{ON125}$. So, if the ambient temperature varies, a threshold value obtained from the equation (20) cannot be used as it is.

If the ratio $(R / R_{ON})$ of a resistance R of the current path to an on-resistance Ron of the FET 60 at an arbitrary ambient temperature is equal to $(R_0 / R_{ON125})$, $(t_{B0} / t_{C0})$ does not depend on the ambient temperature, but is a constant value. That is, for an on-resistance Ron at an arbitrary ambient temperature lower than the upper temperature limit 125 degree Celsius (°C), an overcurrent is selected which flows through the current path of which a resistance R satisfies the equation [R / R_0 = R_{ON} / R_{ON125}], namely [R = R_0 × R_{ON} / R_{ON125}]. Then the equation (20) can be derived from a $V_{DS}$ curve which is obtained by multiplying the selected overcurrent by Ron.

This means that the current reaching value of the overcurrent based on the threshold value is varied by the ambient temperature, that is, a lower limit of an overcurrent which can be protected by the increasing rate of $V_{DS}$ is minimum when the ambient temperature in the vicinity of the FET 60 is at the upper temperature limit 125 degrees Celsius (°C) and then becomes larger as the ambient temperature is lowered from 125 degrees Celsius (°C). If this condition concerning the ambient temperature is satisfied, $(t_{B0} / t_{C0})$ is a fixed value independent of the ambient temperature. Therefore, $(t_{B0} / t_{C0})$ can be used as the threshold value to detect the increasing rate of $V_{DS}$.

Since a temperature coefficient of $R_{ON}$ of an N type MOSFET is normally about 5000 ppm / degree Celsius (°C), $R_{ON}$ at the ambient temperature of 25 degrees Celsius (°C) is (1 / 1.5) times smaller than $R_{ON125}$. Therefore, the lower limit of an overcurrent which can be protected by detecting the increasing rate of $V_{DS}$ at the ambient temperature of 25 degrees Celsius (°C) is 1.5 times larger than the lower limit of the overcurrent at the ambient temperature of 125 degrees Celsius (°C).

If an overcurrent cannot be protected by detecting the increasing rate of $V_{DS}$, the overcurrent must be protected by detecting $V_{DS}$ (magnitude of $V_{DS}$).

Therefore, the maximum magnitude of the overcurrent which must be protected by detecting $V_{DS}$ (magnitude of $V_{DS}$) becomes larger as the ambient temperature decreases, so that an amount of a temperature increase of the FET 60 (namely, a difference between a channel temperature of the FET 60 and an ambient temperature in the vicinity of the FET 60) caused by turning off the FET 60 increases. However, this amount of the temperature increase of the FET 60 is canceled by a decrease of the ambient temperature. Thus, $(t_{B0}/t_{C0})$ can be so set that the channel temperature of the FET 60 at an arbitrary ambient temperature does not exceed a reaching value of the channel temperature of the FET 60 caused by turning off (shutting down) the FET 60 by detecting $V_{DS}$ (magnitude of $V_{DS}$) at the upper temperature limit of 125 degrees Celsius (°C) of the ambient temperature.

$t_B$ and tc of the ratio of $V_{DS}$ reaching times $(t_B / t_C)$ are time interval which are measured from a starting point $(t = 0)$ at which a current begins to flow (begins to increase). In this embodiment, a time point at which $[V_G > V_1]$ is satisfied is used as the starting point $(t = 0)$.

Therefore, when the overcurrent is detected by the increasing rate of $V_{DS}$, the time tc which is required to reach a lower threshold value $V_{DSC}$ is measured at first. Then, a time interval $T_{82}$ is set according to the equation (21) by using the measured time tc.

$$T_{82} = K \times t_C + \alpha \qquad (21)$$

K is a constant value $(= t_{B0} / t_{C0})$. $\alpha$ is a constant value to correct an effect caused by an overcurrent which has a definite value instead of zero at the point when $[V_G > V_1]$ is satisfied (start point of measuring $t_B$ and $t_C$).

$[T_{82} = K \times N_{83} \times T_C + \alpha]$ of the above-mentioned equation (13) is equivalent to the equation (21). That is, $(N_{83} \times T_C)$ corresponds to the time $t_C$.

The time interval $T_{82}$ is set in the counter 82. The time tc is measured by the counter 83 and is output to the counter 82. Whether or not $V_{DS}$ reaches $V_{DSB}$ within the time interval $T_{82}$ is determined by the D type flip-flop 80 and the counter 82.

Instead of obtaining $T_{82}$ according to the equation (21) every time, $T_{82}$ may be read out from a correspondence table, which is calculated according to tc in advance and is written to the correspondence table.

Inductance per unit length of a current path is about 1 micro henry ($\mu$H) / m, and inductance L of the current path is proportional to a length of the current path. Resistance R of the current path increases as the length of the current path is long, that is, the resistance R included in the equation (19) increases. The condition that R is a constant value is not perfectly satisfied if inductance L varies, so that K included in the equation (21) does not precisely become a constant value. If this deviation is not tolerable, it is necessary to correct the deviation. For example, a correspondence table in consideration of the deviation is prepared, and appropriate $T_{82}$ can be set by using this correspondence table.

Operation of the second overcurrent protection signal generating circuit 8 is explained.

($[V_{DS} \leq V_{DSC}]$ is satisfied.)

After the switch 11 is turned on (turn on the FET 60), the output of the comparator 53 becomes H when $[V_G > V_1]$ is satisfied. This timing point is set as to which is the starting point for measuring time concerning detecting operation.

When the outputs of the comparator 53 and the timer 73 become H ("T mode"), the output H from the AND circuit 86 is applied to the clock circuit 85, the counters 83 and 82 as a reset release signal. Thereby, the clock circuit 85 outputs a clock signal and the counter 82 counts up the clock signal.

The time when $[V_G = V_1]$ is satisfied is set as the time to. But, let $V_{DSt0}$ represent the drain-source voltage $V_{DS}$ of the FET 60 at the time to, and $V_{th}$ represent the threshold voltage of the FET 60, $[V_G - V_2 \approx V_{th}]$ is satisfied. Since $[V_G = V_1]$ is satisfied at the time $t_0$, $[V_{DSt0} = V_1 - V_2 \approx V_{th}]$ is established. Since $V_{th}$ is 3 to 4V, $V_{DS10}$ is 3 to 4V.

On the other hand, $V_{DSA}$ at the time when the output of the comparator 33 becomes H in the "I mode" is at most 100 mV, so $[V_{DSt0} > V_{DSA}]$ is satisfied. Thus, the output of the comparator 33 becomes H just after to, and thereby the output of the timer 73 becomes H. Namely, a transition from the "I mode" to the "T mode" occurs.

After to, $V_{DS}$ decreases rapidly and $V_Y$ is reduced by the flow of $I_5$ in the "T mode", so that the output of the comparator 33 returns to L.

During $[V_{DS} \leq V_{DSC}]$ is satisfied after to, the output of the comparator 34 is H. At this time, the output of the AND circuit 84 is a clock signal corresponding to a clock generated from the clock circuit 85. This output is applied to the counter 83 and counted up by the counter 83.

Since $[V_{X1} > V_Y]$ is satisfied, $[V_X > V_Y]$ is satisfied. So the output of the comparator 33 is L and the output of the AND circuit 74 is L.

($[V_{DS} > V_{DSC}]$ is satisfied. : end of measurement of $t_C$)

This time point is the time point when $V_{DS}$ curves 1 to 3 shown in Fig. 6 reach $V_{DSC}$. A time tc which is required to reach this time point is different according to the increasing rate of the $V_{DS}$ curve. It is understood from Fig. 6 that the larger the increasing rate is, the shorter the time $t_C$ which is required to reach $V_{DSC}$ is ($t_{C1} < t_{C2} < t_{C3}$).

When $[V_{DS} > V_{DSC}]$ is satisfied, the output of the comparator 34 becomes L. Thus, the output of the clock signal from the AND circuit 84 is stopped, so that the counting by the counter 83 is stopped.

A count value at the time when the counting by the counter 83 is stopped is a first count value (first count number) $N_{83}$. Regarding each $N_{83}$ of $V_{DS}$ curves 1, 2 and 3 as $N_{831}$, $N_{832}$ and $N_{833}$ and the clock period as $T_C$, $t_{C1}$, $t_{C2}$ and $t_{C3}$ are represented as follows.

$$t_{C1} = N_{831} \times T_C.$$

$$t_{C2} = N_{832} \times T_C.$$

$$t_{C3} = N_{833} \times T_C.$$

The counter 83 outputs the time $t_C$ (= $N_{83} \times T_C$), which is a time interval until the counting is stopped, to the counter 82.

When the counter 82 receives the time $t_C$ from the counter 83, the counter 82 calculates an increasing rate detecting time $T_{82}$ according to the above-mentioned equation (13) $[T_{82} = K \times N_{83} \times T_C + \alpha]$ and sets it in the counter 82. Let $T_{821}$, $T_{822}$ and $T_{823}$ represent each $T_{82}$ of $V_{DS}$ curves 1, 2 and 3. The counter 82 continues to count and maintains H at the inverted output terminal Q-bar until a count period reaches $T_{82}$. When the count period reaches $T_{82}$, the output of the inverted output terminal Q-bar of the counter 82 becomes L.

($[V_{DS} > V_{DSB}]$ is satisfied. ; overcurrent determination time)

This time point is the time point when $V_{DS}$ curves 1 to 3 shown in Fig. 6 reach $V_{DSB}$. Regarding a count value of the counter 82 (hereinafter, referred to as the "second count value") at this time point as $N_{B1}$, $N_{B2}$ and $N_{B3}$ each corresponding to the $V_{DS}$ curves 1, 2 and 3. Times $t_{B1}$, $t_{B2}$ and $t_{B3}$ when the $V_{DS}$ curves 1, 2 and 3 reach $V_{DSB}$ are represented as follows.

$$t_{B1} = N_{B1} \times T_C \qquad (22)$$

$$t_{B2} = N_{B2} \times T_C \qquad (23)$$

$$t_{B3} = N_{B3} \times T_C \qquad (24)$$

Since the $V_{DS}$ curve 2 corresponds to the threshold value ($t_{B0}$ / $t_{C0}$), $T_{822}$ is equal to $t_{B2}$ $[(T_{822} = t_{B2})]$. Thus, $[T_{821} > t_{B1}]$ and $[T_{823} < t_{B3}]$ are satisfied.

When $V_{DS}$ reaches $V_{DSB}$, the output of the comparator 33 becomes H, so that the output of the AND circuit 74 is changed from L to H. This output H from the AND circuit 74 is applied to the clock terminal CLK of the D type flip-flop 80.

When the clock terminal CLK of the D type flip-flop 80 receives H while the reset terminal R-bar of the D type flip-flop 80 receives H (within $T_{82}$), the output terminal Q of the D type flip-flop 80 becomes H. Thus, the control circuit 16 turns off the FET 60.

The $V_{DS}$ curve 1 shown in Fig. 6 corresponds to this case, since $[V_{DS} > V_{DSB}]$ is satisfied at the time $t_{B1}$ (= $N_{B1} \times T_C$) within the increasing rate detecting time $T_{821}$ which is set by the counter 82 in the case of the $V_{DS}$ curve 1.

Even if the clock terminal CLK of the D type flip-flop 80 receives H while the reset terminal R-bar of the D type flip-flop 80 receives L (after lapse of $T_{82}$), the output terminal Q of the D type flip-flop 80 is maintained at L. That is, since the increasing rate of $V_{DS}$ is smaller than the reference value, overcurrent protection is not provided.

In the case of the $V_{DS}$ curve 3 shown in Fig. 6, $[V_{DS} > V_{DSB}]$ is satisfied at the time $t_{B3}$ (= $N_{B3} \times T_C$) after the increasing rate detecting time $T_{823}$ has elapsed. Thus, the increasing rate of $V_{DS}$ is smaller than the increasing rate corresponding to the threshold value ($t_{B0} / t_{C0} = T_{821} / t_{C1} = T_{822} / t_{C2} = T_{823} / t_{C3}$).

[Second embodiment]

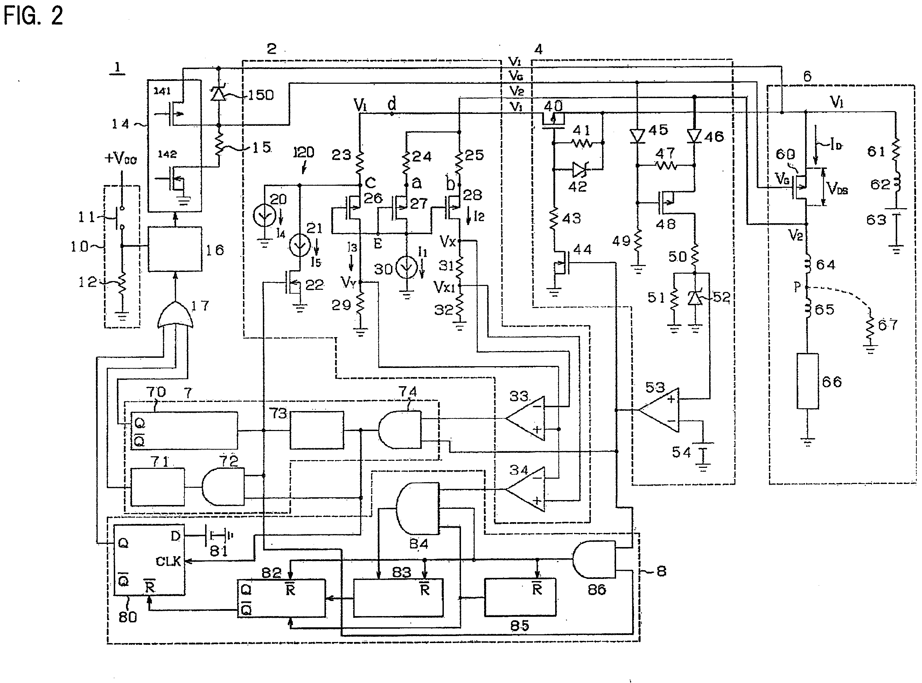

Fig. 2 shows a second embodiment of the overcurrent protection power supply apparatus of the present invention. The same components as those in Fig. 1 are denoted by the same symbols.

A first difference with the first embodiment is that a P type MOSFET is used as the FET 60.

A second difference is that a Zener diode 150 is arranged between a source and a gate of the FET 60. Thus, a gate-source voltage of the FET 60 generated between the source and the gate of the FET 60 can be prevented from being larger than a Zener voltage such as 15V.

A third difference is that the input terminals of the comparator 53 are exchanged each other. That is, the inverted input terminal of the comparator 53 is connected to the DC power source 54 and the non-inverted input terminal is connected to the connecting point between the Zener diode 52 and the resistor 50.

A fourth difference is that the charge pump circuit 13 shown in Fig. 1 is deleted because of using a P type MOSFET as the FET 60.

A fifth difference is that the anode of diode 46 is connected to the $V_2$ line instead of the $V_1$ line.

The others are identical with Fig. 1. In this embodiment, $V_1$ is a source voltage and $V_2$ is a drain voltage of the FET 60.

The source of the FET 60 corresponds to "one of electrodes of the FET which is connected to the DC power source" of the present invention and the drain of the FET 60 corresponds to "another electrode of the FET which is connected to the load" of the present invention.

When the FET 141 of the drive circuit 14 is in on-state (the FET 142 is in off-state), the gate and the source of the FET 60 are short circuited ($[V_G = V_1]$), so that the FET 60 is in off-state.

The gate voltage of the FET 48 is lower by a forward voltage (0.6V) of the diode 45 than $V_G$. On the other hand, since $V_G$ is larger than $V_2$ ($[V_G > V_2]$), the diode 46 is biased inversely, so that no current flows through the resistor 47. Thus, an electrical potential difference between both ends of the resistor 47 is zero, so that the FET 48 is in off-state. Thereby, the output of the comparator 53 is L.

When the FET 142 of the drive circuit 14 turns on (the FET 141 turns off), the gate of the FET 60 is grounded via the resistor 15, so that the gate voltage $V_G$ decreases toward a voltage which is lower (by about 15V) than source voltage $V_1$. When ($V_1$ - $V_G$) exceeds the threshold voltage of the FET 60, the FET 60 turns on and then the drain voltage $V_2$ increases.

When $V_2$ approaches $V_1$ and then $V_2$ becomes larger than $V_G$ ($[V_G < V_2]$), a voltage generated by dividing $V_2$ with the resistors 47 and 49 is applied to the gate of the FET 48, so that the FET 48 turns on. Thereby, the output of the comparator 53 becomes H. Hereinafter, the same operation is performed as the first embodiment shown in Fig. 1.

[Third embodiment]

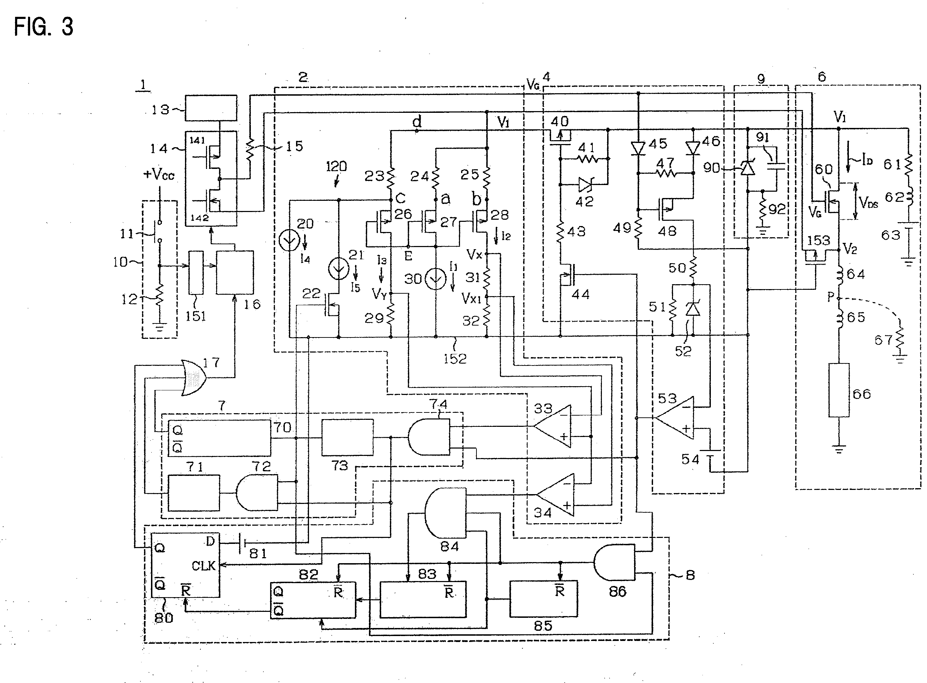

Fig. 3 shows a third embodiment of the overcurrent protection power supply apparatus of the present invention. The same components as those in Fig. 1 are denoted by the same symbols.

According to the first embodiment, a positive electrode and a negative electrode of the drain-source voltage detecting circuit 2 and the drain-source voltage detection starting circuit 4 are connected to the positive electrode and the negative electrode of the DC power supply circuit 6 respectively. Therefore, it is necessary for FETs to have a breakdown voltage higher than the power supply voltage of the DC power source 63 when these FETs are used in the drain-source voltage detecting circuit 2 and the drain-source voltage detection starting circuit 4. For example, if the voltage of the DC power source 63 is 500V, a FET of which a breakdown voltage is larger than 500V must be used. However, such FET having a high breakdown voltage has a large chip area, and thereby a chip area (chip size) for IC increases when a circuit using these FETs is integrated into IC. In this case, parasitic capacitance of the FET increases, so that responsibility of the FET deteriorates and on the other hand, cost penalty increases.

According to the third embodiment, a constant voltage circuit 9 which supplies a constant voltage lower than the power supply voltage of the DC power source 63 is provided. Thus, a FET having a low breakdown voltage can be used in the drain-source voltage detecting circuit 2 and the drain-source voltage detection starting circuit 4.

In Fig. 3, a constant voltage circuit 9 is arranged between the electric power supply circuit 6 and the drain-source voltage detection starting circuit 4. The constant voltage circuit 9 comprises a Zener diode 90 of which a cathode is connected to one of electrodes of the FET 60 which is connected to the DC power source 63, a resistor 92 of which one end is connected to the anode of the Zener diode 90 and the other end is connected to the ground, and a capacitor 91 of which both ends are connected to the both ends of the Zener diode 90.

A Zener voltage generated between both ends of the Zener diode 90 is applied to the drain-source voltage detecting circuit 2 and the drain-source voltage detection starting circuit 4. Negative electrodes of the drain-source voltage detecting circuit 2 and the drain-source voltage detection starting circuit 4 are connected to a connecting point between the Zener diode 90 and the resistor 92 via a negative electrode line 152.

Overcurrent protecting operation of this embodiment is the same as that of the first and the second embodiments.

The capacitor 91 connected in parallel with the Zener diode 90 has a function of keeping the voltage at constant value by absorbing a voltage variation between $V_1$ and the ground. Furthermore, it has a function of being able to reduce an effect due to a high frequency voltage vibration (noise) applied from the outside.

A photo coupler 151 is provided optionally to separate electrically the control circuit 16 from the switch circuit 10.

In Fig. 3, an N type MOSFET is used as the FET 60. However, a P type MOSFET can be used as the FET 60.

[Fourth embodiment]

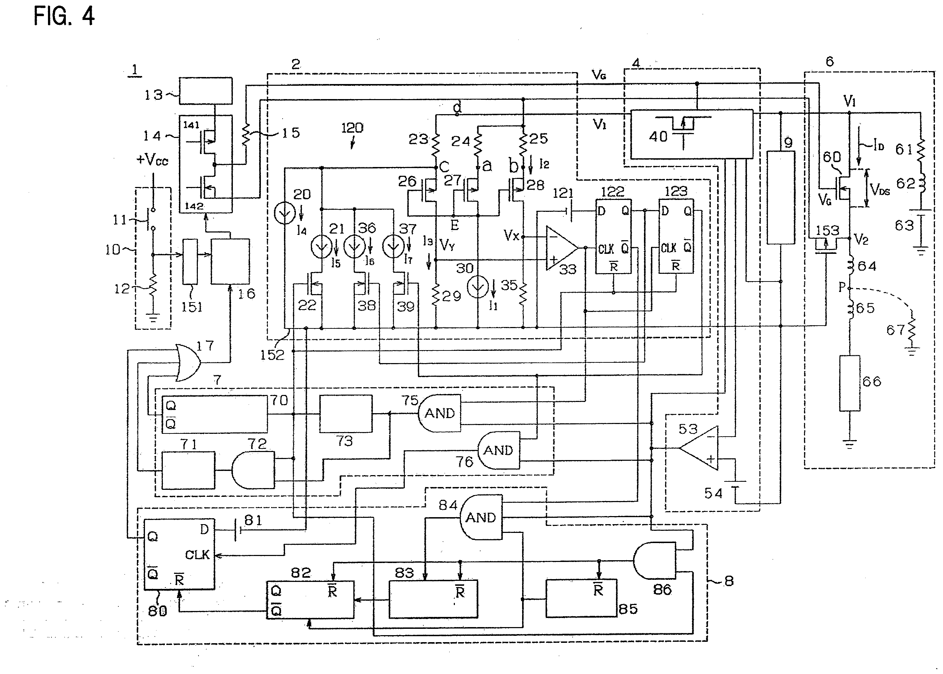

Fig. 4 shows a fourth embodiment of the overcurrent protection power supply apparatus of the present invention. The same components as those in Fig. 3 are denoted by the same symbols.

A drain-source voltage detecting circuit 2 used in this embodiment is different from the drain-source voltage detecting circuit 2 used in the third embodiment shown in Fig. 3 as follows.

(1) A resistor 35 is used instead of the resistors 31 and 32.
(2) The comparator 34 is deleted.
(3) D type flip-flops 122 and 123 are added which process the output of the comparator 33.
(4) The number of the constant current source circuits in parallel include in the detecting voltage reducing circuit 120 is increased.

The resistor 35 is arranged between a drain of a FET 28 and the negative electrode line 152. Resistance of the resistor 35 is set to be equal to the resistance of the resistor 29 which is arranged between the FET 26 and the negative electrode line 152. A voltage generated between both ends of the resistor 35 is denoted as $V_X$.

The comparator 33 compares $V_X$ with $V_Y$. $V_X$ is applied to the inverted input terminal of the comparator 33 and $V_Y$ is applied to the non-inverted input terminal of the comparator 33. The output of the comparator 33 is connected to each clock terminal CLK of the D type flip-flops 122 and 123 and to one of input terminals of an AND circuit 75 of the first overcurrent protection signal generating circuit 7.

A terminal D of the D type flip-flop 122 is connected to a positive electrode of a DC power source 121 of which a negative electrode is connected to the negative electrode line 152. An output Q of the D type flip-flop 122 is connected to a terminal D of the D type flip-flop 123 and a gate of a FET 38. An output Q of the D type flip-flop 123 is connected to a gate of a FET 39 and to one of input terminals of an AND circuit 76.

The first overcurrent protection signal generating circuit 7 of this embodiment is different from that of the third embodiment shown in Fig. 3 as follows.

(1) The AND circuit 74 used in the third embodiment is deleted and AND circuits 75 and 76 are added.
(2) The output of the timer 73 is also applied to inverted reset terminals R-bar of the D type flip-flops 122 and 123.

Input terminals of the AND circuit 75 are connected to the output terminals of the comparators 33 and 53. An output terminal of the AND circuit 75 is connected to the input terminals of the timer 73 and the AND circuit 72.

Input terminals of the AND circuit 76 are connected to an output terminal Q of the D type flip-flop 123 and the output terminal of the comparator 53. An output of the AND circuit 76 is connected to the clock terminal CLK of the D type flip-flop 80.

The overcurrent protection power supply apparatus of this embodiment operates as follows.

([$V_G < V_1$] is satisfied.)

When the FET 60 is in off-state or [$V_G < V_1$] is satisfied even if the FET 60 turns on, the output of the comparator 53 is L. Thus, the output of the timer 73 is L, so that the FET 22 is in off-state. D type flip-flops 122 and 123 are reset, so that FETs 38 and 39 are in off-state. $I_1$ and $I_2$ flow, but $I_3$ to $I_7$ do not flow since the FET 40 is in off-state..

([$V_G > V_1$] is satisfied.)

When [$V_G > V_1$] is satisfied, the output of the comparator 53 becomes H, so that the FET 40 turns on. Thus, $I_4$ flows and "I mode" starts.

$V_{DS}$ is larger than $V_{DSA}$ just after [$V_G > V_1$] is satisfied. Thus, [$V_Y > V_X$] is satisfied, and thereby the output of the comparator 33 becomes H.

Outputs of the AND circuit 75, the timer 73 and the AND circuit 86 becomes H since outputs of the comparators 53 and 33 becomes H. Resets of counters 82, 83 and the clock circuit 85 are released due to the output H from the AND circuit 86. Thus, the clock circuit 85 outputs the clock to the AND circuit 84 and the counter 82.

Further, the "T mode" starts and resets of the D type flip-flops 122 and 123 are released due to the output H from the timer 73. When the "T mode" starts, the FET 22 turns on, so that $I_5$ starts to flow. In this state, $I_1$, $I_4$ and $I_5$ flow, but $I_6$ and $I_7$ do not flow. Thus, the threshold value $V_{DSC}$ of the T mode is set.

When $I_5$ starts to flow, $I_3$ decreases by $I_5$, so that $V_Y$ is reduced. Thus, [$V_Y < V_X$] is satisfied, and thereby the output of the comparator 33 returns to L.

Since the output of the inverted output terminal Q-bar of the D type flip-flop 122 is maintained at H, the AND circuit 84 passes the clock signal from the clock circuit 85 to the counter 83 and the counter 83 counts up the input clock signal.

($I_D$ increases and then $V_{DS}$ reaches $V_{DSC}$ ([$V_{DS} > V_{DSC}$]).)

When $V_Y$ increases due to the increase of $I_D$ ($V_{DS}$) and then [$V_Y > V_X$] ([$V_{DS} > V_{DSC}$]) is satisfied, the output of the comparator 33 becomes H. Thus, the output Q-bar of the D type flip-flop 122 becomes L and the output Q of the D type flip-flop 122 becomes H.

When the output Q-bar of the D type flip-flop 122 becomes L, the output of the AND circuit 84 becomes L, so that the counting by the counter 83 is stopped. At this time, the counter 83 calculates $t_C$ by multiplying a count value (count number) counted up already by a clock period $T_C$ and outputs the calculated tc to the counter 82. The counter 82 sets an increasing rate detecting time $T_{82}$ based on tc input from the counter 83 and maintains the output H from the output Q-bar until the increasing rate detecting time $T_{82}$ has elapsed.

When the output Q of the D type flip-flop 122 becomes H, the FET 38 turns on. In this state, $I_1$, $I_4$, $I_5$ and $I_6$ flow, but $I_7$ does not flow. Thus, the threshold value $V_{DSB}$ of the T mode is set.

When $I_6$ starts to flow, $I_3$ decreases by $I_6$, so that $V_Y$ is reduced. Thus, [$V_Y < V_X$] is satisfied, and thereby the output of the comparator 33 returns to L.

($I_D$ increases and then $V_{DS}$ reaches $V_{DSB}$ ([$V_{DS} > V_{DSB}$]).)

When $V_Y$ increases due to the increase of $I_D$ ($V_{DS}$) and then [$V_Y > V_X$] ([$V_{DS} > V_{DSB}$]) is satisfied, the output of the comparator 33 becomes H. Thus, the output Q-bar of the D type flip-flop 123 becomes L and the output Q of the D type flip-flop 123 becomes H.

When the output Q of the D type flip-flop 123 becomes H, the output of the AND circuit 76 becomes H, and also the FET 39 turns on.

The output H from the AND circuit 76 is applied to the clock input terminal CLK of the D type flip-flop 80. The reset terminal R-bar of the D type flip-flop 80 is applied with H from the counter 82 until the increasing rate detecting time $T_{82}$ has elapsed. When the output H from the AND circuit 76 is applied to the clock input terminal CLK of the D type flip-flop 80 within the increasing rate detecting time $T_{82}$, the output Q of the D type flip-flop 80 becomes H. This output H from the D type flip-flop 80 is applied to the control circuit 16 via the OR circuit 17. On the other hand, when the output H from the AND circuit 76 is applied to the clock input terminal CLK of the D type flip-flop 80 after the increasing rate detecting time $T_{82}$ has elapsed, the output Q of the D type flip-flop 80 is maintained at L.

When the FET 39 turns on, currents $I_1$, $I_4$, $I_5$, $I_6$ and $I_7$ flow. Thus, the threshold value $V_{DSD}$ of the T mode is set.

When $I_7$ starts to flow, $I_3$ decreases by $I_7$, so that $V_Y$ is reduced. Thus, [$V_Y < V_X$] is satisfied, and thereby the output of the comparator 33 returns to L.

($I_D$ increases and then $V_{DS}$ reaches $V_{DSD}$ ($[V_{DS} > V_{DSD}]$).)

When $V_Y$ increases due to the increase of $I_D$ ($V_{DS}$) and then $[V_Y > V_X]$ ($[V_{DS} > V_{DSD}]$) is satisfied, the output of the comparator 33 becomes H. Thus, the output of the AND circuit 75 becomes H. The output H from the AND circuit 75 is applied to one of input terminals of the AND circuit 72 and the timer 73. In this case, since an addition of a current drawn from the point c to reduce $V_Y$ does not occur, the output of the comparator 33 is maintained at H, so that each output of the AND circuits 75 and 72 is maintained at H.

The output of the AND circuit 72 is applied to the digital filter 71. When the output H from the AND circuit 72 is maintained for a predetermined period, the output of the digital filter 71 becomes H, so that the overcurrent protection signal inputs to the control circuit 16.

This embodiment has following advantages.

According to this embodiment, just before the output of the comparator 33 becomes H after $[V_Y = V_X]$ is satisfied, both drain currents of FETs 26 and 28 which generate $V_Y$ and $V_X$ respectively are equal, so that there is no electric potential difference between both sources of the FETs 26 and 28. Thus, when setting the threshold value, it is not affected by $R_{ON1}$ included in the equation (12), and thereby the threshold value can be set precisely.

Though in the first to the third embodiment shown in Figs. 1 to 3, reference voltages $V_X$ and $V_{X1}$ are set by using the resistors 31 and 32, but in this embodiment by changing the magnitude of the current drawn from the point c by increasing the constant current sources circuits. Thus, when integrating the overcurrent protection power supply apparatus into IC device, threshold values can be changed by trimming the currents drawn from the point c.

Since symmetry of the drain-source detecting circuit 2 is improved, immunity to high frequency noises is improved.

Since the number of comparators is reduced by implementing equivalent functions with digital circuits, the chip area can be reduced.

[Fifth embodiment]

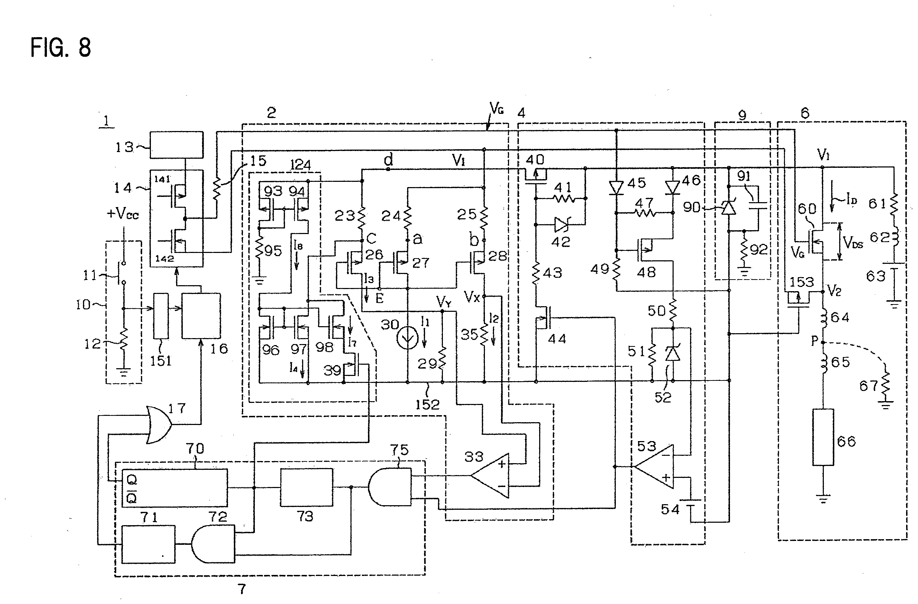

Fig. 8 shows the fifth embodiment of the overcurrent protection power supply apparatus of the present invention. The same components as those of Figs. 3 and 4 are denoted in the same symbols.

Even though an NMOSFET is used as the FET 60 in Fig. 8, a PMOSFET can be used as the FET 60. In this case, the other FETs may be changed if necessary.

According to this embodiment, the second overcurrent protection signal generating circuit 8 shown in Fig. 4 is deleted. Accordingly, the drain-source voltage detecting circuit 2 is modified as follows.

The DC power source 121, the D type flip-flops 122 and 123 are deleted from the drain-source voltage detecting circuit 2 shown in Fig. 4.

A drain-source voltage threshold value setting circuit (hereinafter, referred to as the "$V_{DS}$ threshold value setting circuit") 124 is used instead of the detecting voltage reducing circuit 120.

One example of the $V_{DS}$ threshold value setting circuit 124 is explained.

Between the point d and the ground, a source and a drain of a P type MOSFET 93 and a resistor 95 are arranged in series. Between the point d and the negative electrode line 152, a source and a drain of a P type MOSFET 94, which constitutes a current mirror circuit with the FET 93, and a drain and a source of an N type MOSFET 96 are arranged in series.

N type MOSFETs 97 and 98 constitute a current mirror circuit with the FET 96. A drain of the FET 97 is connected to the source (point c) of the FET 26 and its source is connected to the negative electrode line 152. A drain of FET 98 is connected to the source (point c) of the FET 26 and its source is connected to a drain of an N type MOSFET 39. A source of the FET 39 is connected to the negative electrode line 152 and its gate is connected to the output of the timer 73.

Operation of this embodiment is explained.

($[V_G < V_1]$ is satisfied.)

When the FET 60 is in off-state or $[V_G < V_1]$ is satisfied even if the FET 60 turns on, the output of the comparator 53 is L, so that the FET 40 is in off-state.

Since the output of the comparator 53 is L, the outputs of the AND circuit 75 and the timer 73 are L, so that the FET 39 is in off-state ("I mode").

($[V_G > V_1]$ is satisfied.)

When $[V_G > V_1]$ is satisfied, the output of the comparator 53 becomes H. Thus, the FET 40 turns on, so that $I_3$, $I_4$ and $I_8$ start to flow. Since $V_{DS}$ is larger than $V_{DSA}$ just after $[V_G > V_1]$ is satisfied, $I_3$ flowing through the resistor 29

is larger than $I_2$ flowing through the resistor 35 ($[I_3 > I_2]$). Thus, $[V_Y > V_X]$ is satisfied, so that the output of the comparator 33 becomes H. In this state, since the outputs of comparators 33 and 53 are H, the output of the AND circuit 75 becomes H, so that the output of the timer 73 becomes H. When the output of the timer 73 becomes H, the FET 39 turns on ("T mode").

When $I_7$ starts to flow due to turning on of the FET 39, a current drawn from the point c is $[I_4 + I_7]$. Thus, the threshold value $V_{DSD}$ ($[V_{DSD} = R_{23} (I_4 + I_7)]$) is set. $I_4$ and $I_7$ are proportional to $I_8$. Let $V_{th}$ represent a threshold voltage of the FET 93 and $R_{95}$ represent resistance of the resistor 95, $I_8$ is represented by the equation $[I_8 = (V_1 - V_{th})] / R_{95}]$. Since $V_1$ is much larger than the threshold voltage $V_{th}$ of the FET 93, $I_8$ is nearly proportional to $V_1$. Namely, current $I_4$ and $I_7$ vary according to $V_1$ (nearly proportional to $V_1$). Thus, the threshold value $V_{DSD}$ also varies according to $V_1$ (nearly proportional to $V_1$).

In this specification, the term "according to" means "proportional to" or "nearly proportional to".

When $I_7$ starts to flow, $I_3$ is decreased by $I_7$, so that $I_3$ becomes smaller than $I_2$ ($[I_3 < I_2]$). Thus, $[V_Y < V_X]$ is satisfied, and thereby the output of the comparator 33 returns to L.

(Overcurrent)

When $V_{DS}$ exceeds the threshold value $V_{DSA}$ of the "I mode" due to an increase of $I_D$ and then $[V_X < V_Y]$ is satisfied, the output of the comparator 33 becomes H, so that the output of the AND circuit 75 becomes H. Thus, the output of the timer 73 becomes H during the timer period Ts, and thereby the FET 39 turns on ("T mode").

When $I_7$ starts to flow in the T mode, $I_3$ ($V_Y$) is decreased. Thus, $[V_X > V_Y]$ is satisfied, so that the output of the comparator 33 returns to L. The output H from the timer 73 is maintained during the timer period $T_S$.

(Minor overcurrent)

When a minor overcurrent flows, after the T mode starts in which $V_Y$ is reduced, the state in which $[V_X > V_Y]$ is satisfied is maintained during the timer period $T_S$. And, after the timer period $T_S$ has elapsed, the output of the timer 73 returns to L, so that the FET 39 turns off ("I mode"). When the FET 39 turns off, reducing of $V_Y$ is stopped. The counter 70 counts up a count value whenever the output of the timer 73 becomes H (every "T mode").

Operation performed when the minor overcurrent flows is the same as the first to the fourth embodiments.

(Major overcurrent)

When a major overcurrent flows, $V_{DS}$ continues to increase after T mode starts, and the reduced $V_Y$ turns to increase immediately. And, before the timer period Ts has elapsed, $V_{DS}$ reaches $V_{DSB}$, namely, $V_Y$ becomes larger than $V_X$ ($[V_X < V_Y]$). When $V_Y$ becomes larger than $V_X$, the output of the comparator 33 becomes H, and thereby the output H from the AND circuit 72 is applied to the digital filter 71.

Operation performed when a major overcurrent flows is the same as the first to the fourth embodiments.

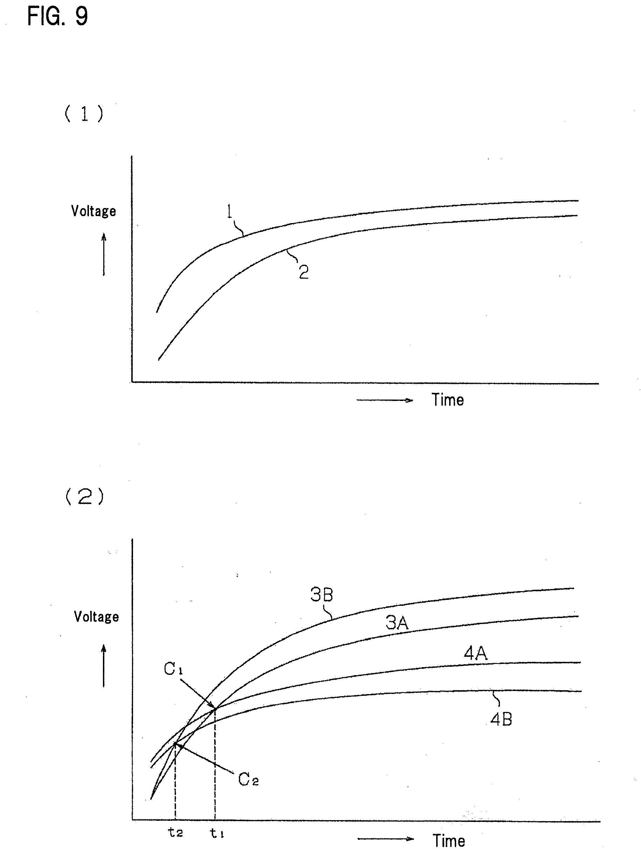

Fig. 9 shows a relation between $V_{DS}$ generated when a rush current or a ground current (ground fault current) flows and a threshold value $V_{DSD}$ at that time. In Fig. 9, the horizontal axis denotes the time and the vertical axis denotes the voltage. Fig. 9 (1) shows the relation between $V_{DS}$ generated when the rush current flows and $V_{DSD}$ at that time. Fig. 9 (2) shows the relation between $V_{DS}$ generated when an overcurrent caused by a ground fault flows and $V_{DSD}$ at that time.

At first, an explanation of Fig. 9 (1) is given. A curve 1 represents a threshold value $V_{DSD}$ used to detect an overcurrent when the rush current flows and a curve 2 represents $V_{DS}$ which is transformed from the rush current. The curve 2 increases rapidly at first, then increases gradually, and then becomes a constant value (saturated). This means that the current $I_D$ flowing through the electric power supply circuit 6 increases rapidly at first and then converges a constant value as it is approaching a saturated state.

Generally, when the FET 60 turns on, a rush current flows through the electric power supply circuit 6. So, it is necessary to prevent overcurrent protection from being provided when the rush current flows. In the other words, it is necessary for the curve 1 to be located above the curve 2 until the rush current reaches the saturated value from zero. If the curve 2 crosses the curve 1 at some point and then exceeds the curve 1 (threshold value), overcurrent protecting operation is performed.

It is explained that a relation between $V_{DSD}$ and $V_{DS}$ is analyzed so that $[V_{DSD} > V_{DS}]$ is attained whenever the rush current flows.

Each of the threshold values $V_{DSA}$ and $V_{DSD}$ is defined as a voltages drop generated between both ends of the resistor 23 (resistance $R_{23}$) by flowing of a current which is drawn from the point c. When only $I_4$ is drawn, $V_{DSA}$ is represented by the equation $[V_{DSA} = R_{23} \times I_4]$. When $I_4$ and $I_7$ are drawn, $V_{DSD}$ is represented by the equation (25).

$$V_{DSD} = R_{23} \times (I_4 + I_7) \qquad (25)$$

The current $(I_4+I_7)$ varies according to $V_1$. In this case, the current $(I_4+I_7)$ can be regarded as a value nearly proportional to $V_1$. Let $K_1$ represent a factor of proportionality, a relation between $(I_4 + I_7)$ and $V_1$ is represented by the equation (26).

$$(I_4 + I_7) = K_1 \times V_1 \qquad (26)$$

The equation (27) can be derived from the equations (25) and (26).

$$V_{DSD} = R_{23} \times K_1 \times V_1 \qquad (27)$$

$V_{DSD}$ at the saturated state can be obtained by substituting $V_1$ at the saturated state into the equation (27). Neglecting the on-resistance $R_{ON}$ of the FET 60, $V_1$ at the saturated state can be obtained as a constant voltage by dividing the power source voltage $V_B$ with resistors $R_{61}$ and $R_{66}$, and is represented by the equation $[V_1 = V_B \times R_{66} / (R_{61} + R_{66})]$.

Thus, $V_{DSD}$ at the saturated state is represented by the equation (28).

$$V_{DSD} = R_{23} \times K_1 \times V_B \times R_{66} / (R_{61} + R_{66}) \qquad (28)$$

When the rush current $I_D$ is not saturated and is increasing yet, a voltage drops (counter electromotive forces) are generated by the inductances in the electric power supply circuit 6, so that $V_1$ at the unsaturated state is smaller than $V_1$ at the saturated state. Since the voltage drops generated by the inductances become larger as an increasing rate of $I_D$ is larger, $V_1$ becomes smaller as the increasing rate of $I_D$ is larger.

The increasing rate of the rush current $I_D$ is large at first, then becomes gradually smaller, namely, monotonously decreases. Thus, $V_1$ gradually increases from a low value and becomes a constant value at saturated state, namely monotonously increases. Therefore, $V_{DSD}$ which is set according to $V_1$ also monotonously increases.

On the other hand, $V_{DS}$ generated when the rush current $I_D$ flows through the FET 60 is represented by the equation (29).

$$V_{DS} = R_{ON} \times I_D \qquad (29)$$

A saturated value of the rush current $I_D$ is represented by the equation (30)

$$I_D = V_B / (R_{61} + R_{66}) \qquad (30)$$

Thus, $V_{DS}$ at the saturated state is represented by the equation (31).

$$V_{DS} = R_{ON} \times I_D = R_{ON} \times V_B / (R_{61} + R_{66}) \qquad (31)$$

The rush current $I_D$ monotonously increases and becomes a maximum value at the saturated state.

At first, it is considered that $[V_{DSD} > V_{DS}]$ would be satisfied at the saturated state when the rush current becomes the maximum value.

The equation (32) is obtained by calculating $[V_{DSD} > V_{DS}]$ by using the equations (28) and (31).

$$R_{23} \times K_1 \times R_{66} > R_{ON} \qquad (32)$$

The equation (33) is obtained by deforming the equation (32)

$$K_1 > R_{ON} / (R_{23} \times R_{66}) \qquad (33)$$

That is, when the rush current $I_D$ is saturated, $V_1$, $V_{DS}$ and $V_{DSD}$ are saturated. $V_{DS}$ is proportional to the rush current $I_D$ and $V_{DSD}$ is proportional to V1. It is understood that the saturated value of $V_{DSD}$ is larger than the saturated value of $V_{DS}$ at this time, if $K_1$ is set to a value which satisfies the equation (33).

If $K_1$ is set to a value which satisfies the equation (33), the equations (32) or (33) is satisfied while $I_D$ increases from zero to the saturated value since each of $R_{ON}$, $R_{23}$ and $R_{66}$ is a constant value and invariable while $I_D$ increases from zero to the saturated value.

When $I_D$ flows through the electric power supply circuit 6, $V_1$ is the sum of a voltage generated between both ends of the load 66 (resistance $R_{66}$) and counter electromotive forces generated by inductances 64 and 65. When $I_D$ monotonously increases, the counter electromotive forces generated by inductances 64 and 65 are directed in the opposite direction of the polarity of the DC power source 63. Thus, it is obvious from a circuit constitution that $V_1$ is larger than the voltage generated between both ends of the load 66 while $I_D$ increases.

Consequently, the equation (34) is satisfied.

$$V_1 \geq R_{66} \times I_D \qquad (34)$$

The equation (35) is obtained from the equations (27) and (34).

$$V_{DSD} = R_{23} \times K_1 \times V_1 \geq R_{23} \times K_1 \times R_{66} \times I_D \qquad (35)$$

The equation (36) is derived from the equations (32) and (35).

$$V_{DSD} > R_{ON} \times I_D \qquad (36)$$

In the equation (36), $I_D$ represents a value from zero to the saturated value and the right side value ($R_{ON} \times I_D$) of the equation (36) represents $V_{DS}$. Thus, the equation (36) shows that [$V_{DSD} > V_{DS}$] is satisfied until the rush current $I_D$ reaches the saturated value from zero. Therefore, if $K_1$ is set to a value which satisfies the equation (33), overcurrent protecting operation **is** not performed when the rush current $I_D$ flows.

When the rush current $I_D$ flows through the FET 60, a resistance between the source of the FET 60 and the ground is $R_{66}$. Let $V_{DSDK1}$ represent a threshold value $V_{DSD}$ which is set by using $K_1$ which satisfies the equation (33) for $R_{66}$. And let $R_X$ represent a resistance between the source of the FET 60 and the ground, wherein $V_{DS}$ transformed from an overcurrent $I_D$ flowing through the resistance $R_X$ is equal to $V_{DSDK1}$ at the saturated state. $V_{DS}$ and $V_{DSDK1}$ at the saturated state are represented as follows.

$$V_{DS} \text{ (saturated)} = R_{ON} \times I_D = R_{ON} \times V_B / (R_{61} + R_X)$$

$$V_{DSDK1} \text{ (saturated)} = R_{23} \times K_1 \times V_1 = R_{23} \times K_1 \times V_B \times R_X / (R_{61} + R_X)$$

Since $V_{DS}$ (saturated) is equal to $V_{DSDK1}$ (saturated), $R_{ON}$ and $R_X$ are represented by the equation (37).

$$R_{ON} = R_{23} \times K_1 \times R_X$$

$$R_X = R_{ON} / (R_{23} \times K_1) \qquad (37)$$

Since the equation (33) is represented as [$R_{66} > R_{ON} / (R_{23} \times K_1)$], $R_X$ is smaller than $R_{66}$. If $V_{DSD}$ is proportional to $V_1$ and the constant of proportionality ($R_{23} \times K_1$) is determined, a resistance $R_X$ is determined by the equation (37), wherein $V_{DSDK1}$ is equal to $V_{DS}$ which is caused by an overcurrent $I_D$ flowing through $R_X$ at the saturated state.

When a resistance between the source of the FET 60 and the ground is smaller than $R_X$, [$V_{DS} > V_{DSD}$] is satisfied at the saturated state, so that the FET 60 turns off.

On the other hand, when the resistance between the source of the FET 60 and the ground is larger than $R_X$, $[V_{DS} < V_{DSD}]$ is satisfied while the overcurrent $I_D$ is increasing from zero to the saturated value, so that the FET 60 does not turn off until a minor overcurrent protection (the output of the counter 70 becomes H) is provided.

$R_X$ is the resistance between the source of the FET 60 and the ground and is a parallel combined resistance of the resistance $R_{66}$ of the load 66 and the ground resistance $R_{67}$ in Fig. 8. $R_X$ is represented as follows.

$$R_X = R_{66} \times R_{67} / (R_{66} + R_{67})$$

When the rush current $I_D$ flows through the load 66, $R_{66}$ is small. However, when a stable current flows through the load 66, $R_{66}$ is larger than $R_{67}$ and $R_X$ is nearly equal to $R_{67}$ ($[R_X \approx R_{67}]$).

It should be noticed that if $K_1$ is determined, $R_X$ is determined according to $K_1$ and that when the resistance between the source of the FET 60 and the ground becomes smaller than $R_X$, an overcurrent flowing at that time is shut down before being saturated regardless of length of a current path from the source of the FET 60 to the ground resistance 67 or to the load 66.

$R_X$ may comprise one resistor or a parallel combined resistance of plural resistors. When the resistance between the source of the FET 60 and the ground become larger than $R_X$, $[V_{DS} < V_{DSD}]$ is satisfied, so that a current flowing through the FET 60 does not shut down by detecting the drain-source voltage (magnitude of the drain-source voltage) of the FET 60 with the threshold value $V_{DSD}$. That is, when $K_1$ is set, $R_X$ according to $K_1$ is determined by the equation (37). And, the overcurrent is determined based on whether or not the resistance between the source of the FET 60 and the ground is smaller than $R_X$.

When the resistance between the source of the FET 60 and the ground is equal to $R_X$, a $V_{DS}$ curve which is transformed from the drain current $I_D$ of the FET 60 is positioned between the $V_{DS}$ curves 1 and 2 shown in Fig. 9 (1) and overlaps a curve of $V_{DSDK1}$ (not shown) at the saturated state.

In the above explanation, $V_{DSD}$ is set at first, and then $R_X$ according to $V_{DSD}$ is determined. In practical overcurrent detection, $R_X$ may be set at first, and then $V_{DSD}$ according to $R_X$ may be determined. The procedure is explained as below.

(1) A current flowing through the FET 60 depends on the resistance between the source of the FET 60 and the ground.

(2) For each current, the lower limit of an overcurrent range in which a current included is judged as the overcurrent is fixed, and then a resistance $R_X$ between the source of the FET 60 and the ground at that time is determined.

(3) Corresponding to $R_X$, $K_1$ which satisfies $[K_1 = R_{ON} / (R_{23} \times R_X)]$ is determined. Then, a threshold value $V_{DSD}$ ($[V_{DSD} = K_1 \times R_{23} \times V_1]$) which is used to detect $V_{DS}$ (magnitude of $V_{DS}$) is set. That is, the threshold value $V_{DSD}$ varies according to $V_1$ (in this case, $V_{DSD}$ is proportional to $V_1$).

(4) When $V_{DSD}$ is set in this manner, $V_{DS}$ is equal to $V_{DSD}$ ($[V_{DS} = V_{DSD}]$) at the saturated state of an overcurrent which depends on a resistance between the source of the FET 60 and the ground and is equal to the lower limit of the overcurrent range (at this time, the resistance between the source of the FET 60 and the ground is $R_X$). On the other hand, $V_{DS}$ is larger than $V_{DSD}$ ($[V_{DS} > V_{DSD}]$) at the saturated state of an overcurrent which flows through the resistance between the source of the FET 60 and the ground smaller than $R_X$ (an overcurrent larger than the lower limit). Therefore, an overcurrent flowing through the resistance between the source of the FET 60 and the ground which is less than or equal to $R_X$ can be detected by comparing $V_{DS}$ with $V_{DSD}$ before the overcurrent becomes saturated.

(5) If the overcurrent range, in which a current is judged as the overcurrent, is changed and thereby $R_X$ has to be changed, $K_1$ is also changed according to $R_X$ and a threshold values (for example, $V_{DSA}$, $V_{DSD}$ and so on) are set.

(6) $K_1$ is determined according to the equation $[K_1 = R_{ON} / (R_{23} \times R_X)]$ (refer to the equation (37)) by using $R_X$. This equation includes $R_{ON}$ which varies due to a channel temperature of the FET 60. Thus, when the channel temperature of the FET 60 varies, $R_{ON}$ varies and also $K_1$ varies. That is, $K_1$ is not a constant value. $K_1$ cannot follow the variation in $R_{ON}$ since $K_1$ is set by the resistance $R_{95}$ of the resistor 95 shown in Fig. 8. Therefore, it is necessary to consider the variation in Ron to provide overcurrent protection securely.

One solution is that $R_X$ is set such that ($R_{ON} / R_X$) becomes constant. For example, $K_1$ is set by using an on-resistance $R_{ON125}$ at the upper temperature 125 degrees Celsius (°C) of an ambient temperature in the vicinity of the FET 60. When the ambient temperature becomes lower than the upper temperature and so $R_{ON}$ becomes smaller than $R_{ON125}$, $R_X$ is reduced in proportion to the decrease of $R_{ON}$ such that the lower limit of the overcurrent range, in which a current is judged as the overcurrent, is increased in reverse proportion to the decrease of Ron. Namely, $V_{DS}$ becomes equal to $V_{DSD}$ ($[V_{DS} = V_{DSD}]$) at the saturated state of an overcurrent of which a magnitude is larger by an amount according to a difference between $R_{ON}$ and $R_{ON125}$ than that of the lower limit of the overcurrent range at the upper ambient temperature 125 degrees Celsius (°C). As an ambient temperature to set $K_1$, an suitable temperature within a temperature range at which operation of the FET 60 is permitted can be selected.

A configuration of "a relation between a threshold value and an electrical potential of an electrode of a FET connected to a DC power source is set such that a magnitude of a drain-source voltage of the FET is equal to the threshold value ($[V_{DS} = V_{DSD}]$) at a saturated state of a current which is the lower limit (a resistance between the FET and the ground is equal to $R_X$) within a current range, in which a current is determined as an overcurrent, and the magnitude of the drain-source voltage is larger than the threshold value ($[V_{DS} > V_{DSD}]$) at a saturated state of a current which is larger than the lower limit (the resistance between the FET and the ground is smaller than $R_X$) is equivalent to a configuration of "a relation between a threshold value and an electrical potential of an electrode of a FET connected to a DC power source is set such that a magnitude of a drain-source voltage of the FET is equal to the threshold value ($[V_{DS} = V_{DSD}]$) at a saturated state of a current flowing through a resistance between the FET and the ground which is the upper limit resistance within a resistance range corresponding to a current range, in which a current is determined as an overcurrent, and the magnitude of the drain-source voltage is larger than the threshold value ($[V_{DS} > V_{DSD}]$) at a saturated state of a current flowing through the resistance between the FET and the ground is smaller than the upper limit resistance".

However, even though the resistance between the FET and the ground is identical, the current flowing through that resistance between the FET and the ground varies depending on composition of a power supplying circuit such as a voltage of a power source, an internal resistance of it, a resistance and an inductance of power supplying wire, and so on. On the contrary, the resistance between the FET and the ground which is an origin of overcurrent does not vary according to the state of the power supplying circuit. Consequently, although the latter is equivalent to the former regarding the effect, it is an appropriate expression that the latter uses the method of evaluating the resistance between the FET and the ground instead of evaluating the magnitude of the current, in order to detect the overcurrent.

Next, an explanation of Fig. 9 (2) is given. In Fig. 9 (2), curves (3A, 4A) regarding a first ground fault (accident A) and curves (3B, 4B) regarding a second ground fault (accident B) are shown. A resistance between the source of the FET 60 and the ground is smaller than $R_X$ in both accidents A and B.

The curve 3A shows the drain-source voltage $V_{DS}$ of the FET 60 through which an overcurrent due to the first ground fault flows. The larger $I_D$ is, the larger $V_{DS}$ is. The curve 4A shows a threshold value $V_{DSD}$ used for detecting the drain-source voltage $V_{DS}$ of the FET 60 when the overcurrent due to the first ground fault flows through the FET 60.

The curve 3B shows the drain-source voltage $V_{DS}$ of the FET 60 through which an overcurrent due to the second ground fault flows. The curve 4B shows a threshold value $V_{DSD}$ used for detecting the drain-source voltage $V_{DS}$ of the FET 60 when the overcurrent due to the second ground fault flows through the FET 60.

In Fig. 8, those ground faults are supposed to occur at the point P in the electric power supply circuit 6. A magnitude of an overcurrent (reaching current value or saturated value: larger either one is, larger an increasing rate of $V_{DS}$ is) caused by the ground fault depends on a ground point, a ground resistance 67, and so on.

Fig. 9 (2) shows that a saturated value of the overcurrent caused by the second ground fault is larger (an increasing rate is larger) than a saturated value of the overcurrent caused by the first ground fault. Thus, the curve 3B increases more rapidly than the curve 3A and the curve 3B is located on the upper side of the curve 3A.

As mentioned above, a saturated value of the voltage $V_1$ is smaller as a reaching value of an overcurrent is large and $V_{DSD}$ which varies according to $V_1$ is also smaller. Thus, $V_{DSD}$ (curve 4B) corresponding to an overcurrent of which a saturated value is relatively larger is smaller than $V_{DSD}$ (curve 4A) corresponding to an overcurrent of which a saturated value is relatively small (the curve 4B is located in the lower side of the curve 4A).

Now, the first ground faults (curves 3A, 4A) are discussed. In the both case of the first ground fault and the second ground fault, a resistance between the source of the FET 60 and the ground is smaller than $R_X$, and thereby $V_{DS}$ generated by an overcurrent $I_D$ becomes larger than the threshold value $V_{DSD}$ at the saturated state.

An initial value of $V_{DS}$ (= $R_{ON} \times I_D$) is zero because $I_D$ starts from zero. An initial value of $V_1$ is not zero because the counter electromotive force is generated by flowing of increasing current through the inductance pertaining to a length of a current path except in a special case when a length of a current path between the FET 60 and the ground point P is zero. Thus, an initial value of $V_{DSD}$ which is set according to $V_1$ is also not zero.

Therefore, $V_{DS}$ starts from smaller value than $V_{DSD}$ at first, then, monotonously increases, and becomes larger than $V_{DSD}$ in the saturated state at last. That is, there is a point where $V_{DS}$ becomes equal to $V_{DSD}$ before reaching the saturated value.

That time point is t1 shown in Fig. 9 (2) which corresponds to an intersecting point $C_1$ where the curve 3A and the curve 4A cross each other. At that point, $V_{DS}$ becomes equal to $V_{DSD}$ ($[V_{DS} = V_{DSD}]$), so that the output of the comparator 33 becomes H. When the output of the comparator 33 becomes H, the process as mentioned above is performed and then the output of the digital filter 71 becomes H, so that the FET 60 turns off to provide the overcurrent protection.

Next, the second ground faults (curves 3B, 4B) are discussed. In this case, a point when $V_{DS}$ becomes equal to $V_{DSD}$ is a time point t2 which corresponds to an intersecting point $C_2$ where the curve 3B and the curve 4B cross each other. So, overcurrent protection is provided at the time point $t_2$.

Comparing $t_1$ and $t_2$, $t_2$ is earlier than $t_1$. The reason is that the intersecting point $C_2$ is the point where the curve 3B of which an increasing rate is larger than that of the curve 3A (locates on the upper side of the curve 3A) and the curve 4B of which a threshold value $V_{DSD}$ is smaller than that of the curve 4A (locates on the lower side of the curve 4A) cross each other, and so the point $C_2$ appears earlier than the point $C_1$ (locates on the left side of the point $C_1$).

This means that the larger the current reaching value (the increasing rate) is, the earlier overcurrent protection is provided. That is, the fifth embodiment is not provided with the second overcurrent protection signal generating circuit 8 which generates the overcurrent protection signal by detecting the increasing rate of $V_{DS}$ as the first to the fourth embodiments. However, the fifth embodiment provide overcurrent protection at an earlier stage as the current reaching value is larger (the increasing rate is larger). As a result, the fifth embodiment practically has an effect that overcurrent protection is provided by detecting the increasing rate of $V_{DS}$ similar to the first to fourth embodiments.

The present invention may be added to, changed, replaced with alternatives or otherwise modified without departing from the scope of the present invention.

Claims specifies the overcurrent protection power supply apparatus having the drain-source voltage detection starting circuit for preventing the switching element from being shut down incorrectly when supplying power.

The power switching element may not be restricted to MOSFET, but other kinds of FETs can be used.

Condition that $V_{DS}$ is larger than a threshold value (for example, $V_{DSA}$, $V_{DSB}$, $V_{DSC}$, $V_{DS}$) ($[V_{DS} >$ threshold value]) can be replaced by condition that $V_{DS}$ is larger than or equal to a threshold value ($[V_{DS} \geq$ threshold value]).

The overcurrent protection power supply apparatus of the present invention is preferably used to supply electric power from a high voltage DC power source to a load, but can be applied for any voltage DC power source.

Each of the power supply circuit, the drain-source voltage detecting circuit, the drain-source voltage detection starting circuit, the first overcurrent protection signal generating circuit and the second overcurrent protection signal generating circuit can be modified without departing from the scope of the invention.

In the embodiments, to set the threshold value according to the drain-source voltage, a reducing circuit for reducing (decreasing) the magnitude of the detecting voltage (detecting signal) is provided. However, a pulling up circuit for pulling up (increasing) the reference voltage (reference signal) can be provided.

Each of the features disclosed above can be utilized separately or in conjunction with other features.

The present invention may be configured as follows.

An overcurrent protection power supply apparatus having a power supply circuit for supplying electric power from a DC power source to a load via a FET and a control circuit for controlling the FET, wherein the control circuit turns off the FET to protect the power supply circuit against an overcurrent, the apparatus comprising

a drain-source voltage detecting circuit for detecting a drain-source voltage generated between a drain and a source of the FET by a drain current flowing through the FET,

a drain-source voltage detection starting circuit for starting drain-source voltage detecting operation of the drain-source voltage detecting circuit after the drain-source voltage increases according to an increase of the drain current of the FET when turning on the FET, and

a first overcurrent protection signal generating circuit which outputs a first overcurrent protection signal based on the drain-source voltage,

wherein the control circuit turns off the FET when the first overcurrent protection signal is output from the first overcurrent protection signal generating circuit, and

wherein the drain-source voltage detecting circuit is configured to detect the drain-source voltage by comparing a magnitude of the drain-source voltage with a threshold value which varies according to an electrical potential of an electrode of the FET which is connected to the DC power source,

wherein a relation between the threshold value and the electrical potential of the electrode of the FET which is connected to the DC power source is set such that when an ambient temperature is at the predetermined one, the magnitude of the drain-source voltage caused by a current flowing through a resistance between the FET and the ground, which is equal to the upper limit within a resistance range corresponding to an overcurrent range, is equal to the threshold value when the resistance between the FET and the ground is smaller than the upper limit, and wherein, when the ambient temperature is lower than the predetermined one, so that an on-resistance of the FET decreases, the magnitude of the drain-source voltage caused by a current flowing through a resistance between the FET and the ground, which is lower by a decrease of the on-resistance of the FET than the upper limit, is equal to the threshold value at a saturated state, and when the ambient temperature is higher than the predetermined one, so that the on-resistance of the FET increases, the magnitude of the drain-source voltage caused by a current flowing through a resistance between the FET and the ground, which is larger by an increase of the on-resistance of the FET than the upper limit, is equal to the threshold value at a saturated state.

The predetermined ambient temperature can be selected suitably from a range between an upper temperature and a lower temperature which is a permissible operating ambient temperature range of the FET.

1 ▪ ▪ ▪ overcurrent protection power supply apparatus, 2 ▪ ▪ ▪ drain-source voltage detecting circuit, 4 ▪ ▪ ▪ drain-source voltage detection starting circuit, 6 ▪ ▪ ▪ electric power supply circuit, 7 ▪ ▪ ▪ first overcurrent protection signal generating circuit, 8 ▪ ▪ ▪ second overcurrent protection signal generating circuit, 9 ▪ ▪ ▪ constant voltage circuit, 10 ▪ ▪ ▪ switch circuit, 11 ▪ ▪ ▪ switch, 12 ▪ ▪ ▪ resistor, 13 ▪ ▪ ▪ charge pump circuit, 14 ▪ ▪ ▪ drive circuit, 15 ▪ ▪ ▪ resistor, 16 ▪ ▪ ▪ control circuit, 17 ▪ ▪ ▪ OR circuit, 20, 21 ▪ ▪ ▪ constant current source, 22 ▪ ▪ ▪ FET, 23-25 ▪ ▪ ▪ resistor, 26-28 ▪ ▪ ▪ FET, 29 ▪ ▪ ▪ resistor, 30 ▪ ▪ ▪ constant current source, 31, 32 ▪ ▪ ▪ resistor, 33, 34 ▪ ▪ ▪ comparator, 35 ▪ ▪ ▪ resistor, 36, 37 ▪ ▪ ▪ constant current source, 38-40 ▪ ▪ ▪ FET, 41 ▪ ▪ ▪ resistor, 42 ▪ ▪ ▪ Zener diode, 43 ▪ ▪ ▪ resistor, 44 ▪ ▪ ▪ FET, 45, 46 ▪ ▪ ▪ diode, 47 ▪ ▪ ▪ resistor, 48 ▪ ▪ ▪ FET, 49-51 ▪ ▪ ▪ resistor, 52 ▪ ▪ ▪ Zener diode, 53 ▪ ▪ ▪ comparator, 54 ▪ ▪ ▪ DC power source, 60 ▪ ▪ ▪ FET, 61 ▪ ▪ ▪ resistor, 62 ▪ ▪ ▪ inductor, 63 ▪ ▪ ▪ DC power source, 64, 65 ▪ ▪ ▪ inductor, 66 ▪ ▪ ▪ load, 67 ▪ ▪ ▪ ground resistor, 70 ▪ ▪ ▪ counter, 71 ▪ ▪ ▪ digital filter, 72 ▪ ▪ ▪ AND circuit, 73 ▪ ▪ ▪ timer, 74-76 ▪ ▪ ▪ AND circuit, 80 ▪ ▪ ▪ D type flip-flop, 81 ▪ ▪ ▪ DC power source, 82, 83 ▪ ▪ ▪ counter, 84 ▪ ▪ ▪ AND circuit, 85 ▪ ▪ ▪ clock circuit, 86 ▪ ▪ ▪ AND circuit, 90 ▪ ▪ ▪ Zener diode, 91 ▪ ▪ ▪ capacitor, 92 ▪ ▪ ▪ resistor, 93, 94 ▪ ▪ ▪ FET, 95 ▪ ▪ ▪ resistor, 96-98 ▪ ▪ ▪ FET, 101 ▪ ▪ ▪ overcurrent protection power supply apparatus, 102 ▪ ▪ ▪ switch circuit, 103 ▪ ▪ ▪ switch, 104 ▪ ▪ ▪ resistor, 105 ▪ ▪ ▪ control circuit, 106 ▪ ▪ ▪ resistor, 107 ▪ ▪ ▪ comparator, 108 ▪ ▪ ▪ overcurrent detecting circuit, 109 ▪ ▪ ▪ multi-source FET, 110 ▪ ▪ ▪ sub FET, 111 ▪ ▪ ▪ main FET, 112 ▪ ▪ ▪ temperature sensor, 113 ▪ ▪ ▪ reference voltage generating circuit, 114 ▪ ▪ ▪ resistor, 115 ▪ ▪ ▪ wire, 116 ▪ ▪ ▪ load, 117, 121 ▪ ▪ ▪ DC power source, 120 ▪ ▪ ▪ detecting voltage reducing circuit, 122, 123 ▪ ▪ ▪ D type flip-flop, 124 ▪ ▪ ▪ drain-source threshold value setting circuit, 141, 142 ▪ ▪ ▪ FET, 150 ▪ ▪ ▪ Zener diode, 151 ▪ ▪ ▪ photo-coupler, 152 ▪ ▪ ▪ negative electrode line, 153 ▪ ▪ ▪ FET

**Claims**

1. An overcurrent protection power supply apparatus (1) having a power supply circuit (6) for supplying electric power from a DC power source (63) to a load (66) via a FET (60) and a control circuit (16) for controlling the FET (60), wherein the control circuit (16) is configured to turn off the FET (60) to protect the power supply circuit (6) against an overcurrent, the apparatus (1) comprising

   a drain-source voltage detecting circuit (2) which is configured to detect a drain-source voltage ($V_{DS}$) generated between a drain and a source of the FET (60) by a drain current ($I_D$) flowing through the FET (60),

   a drain-source voltage detection starting circuit (4) which is configured to start drain-source voltage detecting operation of the drain-source voltage detecting circuit (2) after the drain-source voltage ($V_{DS}$) increases according to an increase of the drain current ($I_D$) of the FET (60) when turning on the FET (60), and

   a first overcurrent protection signal generating circuit (7) which is configured to output a first overcurrent protection signal based on the drain-source voltage ($V_{DS}$) detected by the drain-source voltage detecting circuit (2), **characterised by**

   a second overcurrent protection signal generating circuit (8) which is configured to output a second overcurrent protection signal based on an increasing rate of the drain-source voltage ($V_{DS}$) detected by the drain-source voltage detecting circuit (2),

   wherein the second overcurrent protection signal generating circuit (8) is configured to measure a time interval between a time when the drain-source voltage ($V_{DS}$) becomes larger than a first threshold value and a time when the drain-source voltage ($V_{DS}$) becomes larger than a third threshold value which is larger than the first threshold value and is configured to set a reference time interval which is longer than the measured time interval, and wherein the second overcurrent protection signal generating circuit (8) is configured to output the second overcurrent protection signal when the drain-source voltage ($V_{DS}$) becomes larger than a fourth threshold value which is larger than the third threshold value within the reference time interval from the time when the drain-source voltage ($V_{DS}$) becomes larger than the first threshold value, and

   wherein the control circuit (16) is configured to turn off the FET (60) when the first overcurrent protection signal is output from the first overcurrent protection signal generating circuit (7) or the second overcurrent protection signal is output from the second overcurrent protection signal generating circuit (8).

2. An overcurrent protection power supply apparatus (1) having a power supply circuit (6) for supplying electric power from a DC power source (63) to a load (66) via a FET (60) and a control circuit (16) for controlling the FET (60), wherein the control circuit (16) is configured to turn off the FET (60) to protect the power supply circuit (6) against an overcurrent, the apparatus (1) comprising

   a drain-source voltage detecting circuit (2) which is configured to detect a drain-source voltage ($V_{DS}$) generated between a drain and a source of the FET (60) by a drain current ($I_D$) flowing through the FET (60),

a drain-source voltage detection starting circuit (4) which is configured to start drain-source voltage detecting operation of the drain-source voltage detecting circuit (2) after the drain-source voltage ($V_{DS}$) increases according to an increase of the drain current ($I_D$) of the FET (60) when turning on the FET (60), and

a first overcurrent protection signal generating circuit (7) which is configured to output a first overcurrent protection signal based on the drain-source voltage ($V_{DS}$) detected by the drain-source voltage detecting circuit (2), wherein the control circuit (16) is configured to turn off the FET (60) when the first overcurrent protection signal is output from the first overcurrent protection signal generating circuit (7), and

the drain-source voltage detecting circuit (2) is configured to detect the drain-source voltage ($V_{DS}$) by comparing a magnitude of the drain-source voltage ($V_{DS}$) with a threshold value which varies according to an electrical potential of an electrode of the FET (60) which is connected to the DC power source (63), **characterised in that** the threshold value is equal to the magnitude of the drain-source voltage ($V_{DS}$) at a saturated state of a current flowing through a resistance ($R_X$) between the FET (60) and the ground which is equal to the upper limit within a resistance range corresponding to a current range in which a current is determined as the overcurrent, and the threshold value is lower than the magnitude of the drain-source voltage ($V_{DS}$) at a saturated state of a current flowing through the resistance ($R_X$) between the FET (60) and the ground which is smaller than the upper limit within the resistance range.

3. The overcurrent protection power supply apparatus (1) according to claim 1 or 2 wherein the first overcurrent protection signal generating circuit (7) has a timer (73) which is configured to output a timer signal during a predetermined timer period when the drain-source voltage ($V_{DS}$) becomes larger than a first threshold value, and wherein the first overcurrent protection signal generating circuit (7) is configured to output the first overcurrent protection signal when the drain-source voltage ($V_{DS}$) continues for a predetermined period to be larger than a second threshold value which is larger than the first threshold value or when the number of the timer signals output from the timer (73) reaches a predetermined number.

4. The overcurrent protection power supply apparatus (1) according to one of the claims 1 to 3 wherein the drain-source voltage detecting circuit (2) has a first source follower circuit, a second source follower circuit, a threshold value setting circuit and a comparator, wherein

the first source follower circuit has a first P type MOSFET (28), a source of the first P type MOSFET (28) is connected to an electrode of the FET (60) which is connected to the load (66) via a first resistor (25) and a common gate potential is applied to a gate of the first P type MOSFET (28),

the second source follower circuit has a second P type MOSFET (26), a source of the second P type MOSFET (26) is connected to another electrode of the FET (60) which is connected to the DC power source (63) via a second resistor (23) having a resistance equal to a resistance of the first resistor (25) and the common gate potential is applied to a gate of the second P type MOSFET (26), and wherein the second source follower circuit is configured such that a drain current of the second P type MOSFET (26) varies according to a value derived by subtracting the threshold value used at that time from the drain-source voltage ($V_{DS}$),

the threshold value setting circuit is configured to be able to vary the drain current of the second P type MOSFET (26) by drawing a current, which varies according to an electrical potential of the electrode of the FET (60) which is connected to the DC power source (63), from the source of the second P type MOSFET (26), and

the comparator is configured to detect that the drain current of the second P type MOSFET (26) becomes larger than the drain current of the first P type MOSFET (28).

5. The overcurrent protection power supply apparatus (1) according to one of the claims 1 to 4 wherein an N type MOSFET is used as the FET (60),

and wherein the drain-source voltage detection starting circuit (4) is configured to start drain-source voltage detecting operation of the drain-source voltage detecting circuit (2) when an electrical potential of a gate of the N type MOSFET becomes larger than an electrical potential of a drain of the N type MOSFET.

6. The overcurrent protection power supply apparatus (1) according to one of the claims 1 to 4 wherein a P type MOSFET is used as the FET (60),

and wherein the drain-source voltage detection starting circuit (4) is configured to start drain-source voltage detecting operation of the drain-source voltage detecting circuit (2) when an electrical potential of a gate of the P type MOSFET becomes smaller than an electrical potential of a drain of the P type MOSFET.

7. The overcurrent protection power supply apparatus (1) according to one of the claims 1 to 6 further comprising a constant voltage circuit (9), wherein the constant voltage circuit (9) is configured to keep a voltage which is applied to the drain-source voltage detecting circuit (2) and the drain-source voltage detection starting circuit (4) at a constant magnitude which is smaller than a voltage of the DC power source (63).

**Patentansprüche**

1. Überstromschutzleistungszufuhrvorrichtung (1) mit einer Leistungszufuhrschaltung (6) zum Zuführen elektrischer Leistung von einer Gleichstromleistungsquelle (63) zu einer Last (66) über einen FET (60) und einer Steuerungsschaltung (16) zum Steuern des FET (60), bei der die Steuerungsschaltung (16) dazu ausgebildet ist, den FET (60) zum Schützen der Leistungszufuhrschaltung (6) vor einem Überstrom auszuschalten, welche Vorrichtung (1) aufweist eine drain-source-spannungserfassende Schaltung (2), die dazu ausgebildet ist, eine Drain-Source-Spannung ($V_{DS}$), die zwischen einem Drain und einer Source des FET (60) durch einen Drain-Strom ($I_D$), der durch den FET (60) fließt, erzeugt wird, zu erfassen,

eine Drain-Source-Spannungserfassungsstartschaltung (4), die dazu ausgebildet ist, einen drain-source-spannungserfassenden Betrieb der drain-source-spannungserfassenden Schaltung (2) zu starten, nachdem die Drain-Source-Spannung ($V_{DS}$) gemäß einer Zunahme des Drain-Stroms ($I_D$) des FET (60) zunimmt, wenn der FET (60) eingeschaltet wird, und

eine erste überstromschutzsignalerzeugende Schaltung (7), die dazu ausgebildet ist, ein erstes Überstromschutzsignal basierend auf der Drain-Source-Spannung ($V_{DS}$), die durch die drain-source-spannungserfassende Schaltung (2) erfasst wird, auszugeben, **gekennzeichnet durch** eine zweite überstromschutzsignalerzeugende Schaltung (8), die dazu ausgebildet ist, ein zweites Überstromschutzsignal basierend auf einer Zunahmerate der Drain-Source-Spannung ($V_{DS}$), die durch die drain-source-spannungserfassende Schaltung (2) erfasst wird, auszugeben,

bei der die zweite überstromschutzsignalerzeugende Schaltung (8) dazu ausgebildet ist, ein Zeitintervall zwischen einer Zeit, wenn die Drain-Source-Spannung ($V_{DS}$) größer als ein erster Schwellwert wird, und einer Zeit, wenn die Drain-Source-Spannung ($V_{DS}$) größer als ein dritter Schwellwert, der größer als der erste Schwellwert ist, wird, zu messen, und dazu ausgebildet ist, ein Referenzzeitintervall, das länger als das gemessene Zeitintervall ist, festzulegen, und bei der die zweite überstromschutzsignalerzeugende Schaltung (8) dazu ausgebildet ist, das zweite Überstromschutzsignal auszugeben, wenn die Drain-Source-Spannung ($V_{DS}$) innerhalb des Referenzzeitintervalls von der Zeit, wenn die Drain-Source-Spannung ($V_{DS}$) größer als der erste Schwellwert wird, größer als ein vierter Schwellwert, der größer als der dritte Schwellwert ist, wird, auszugeben, und

bei der die Steuerungsschaltung (16) dazu ausgebildet ist, den FET (60) auszuschalten, wenn das erste Überstromschutzsignal von der ersten überstromschutzsignalerzeugenden Schaltung (7) ausgegeben wird oder das zweite Überstromschutzsignal von der zweiten überstromschutzsignalerzeugenden Schaltung (8) ausgegeben wird.

2. Überstromschutzleistungszufuhrvorrichtung (1) mit einer Leistungszufuhrschaltung (6) zum Zuführen elektrischer Leistung von einer Gleichstromleistungsquelle (63) zu einer Last (66) über einen FET (60) und einer Steuerungsschaltung (16) zum Steuern des FET (60), bei der die Steuerungsschaltung (16) dazu ausgebildet ist, den FET (60) zum Schützen der Leistungszufuhrschaltung (6) vor einem Überstrom auszuschalten, welche Vorrichtung (1) aufweist eine drain-source-spannungserfassende Schaltung (2), die dazu ausgebildet ist, eine Drain-Source-Spannung ($V_{DS}$), die zwischen einem Drain und einer Source des FET (60) durch einen Drain-Strom ($I_D$), der durch den FET (60) fließt, erzeugt wird, zu erfassen,

eine Drain-Source-Spannungserfassungsstartschaltung (4), die dazu ausgebildet ist, einen drain-source-spannungserfassenden Betrieb der drain-source-spannungserfassenden Schaltung (2) zu starten, nachdem die Drain-Source-Spannung ($V_{DS}$) gemäß einer Zunahme des Drain-Stroms ($I_D$) des FET (60) zunimmt, wenn der FET (60) eingeschaltet wird, und

eine erste überstromschutzsignalerzeugende Schaltung (7), die dazu ausgebildet ist, ein erstes Überstromschutzsignal basierend auf der Drain-Source-Spannung ($V_{DS}$), die durch die drain-source-spannungserfassende Schaltung (2) erfasst wird, auszugeben, bei der die Steuerungsschaltung (16) dazu ausgebildet ist, den FET (60) auszuschalten, wenn das erste Überstromschutzsignal von der ersten überstromschutzsignalerzeugenden Schaltung (7) ausgegeben wird, und

die drain-source-spannungserfassende Schaltung (2) dazu ausgebildet ist, die Drain-Source-Spannung ($V_{DS}$) durch Vergleichen eines Betrags der Drain-Source-Spannung ($V_{DS}$) mit einem Schwellwert, der entsprechend einem elektrischen Potential einer Elektrode des FET (60), die mit der Gleichstromleistungsquelle (63) verbunden ist, variiert, zu erfassen, **dadurch gekennzeichnet, dass** der Schwellwert gleich dem Betrag der Drain-Source-Spannung ($V_{DS}$) bei einem gesättigten Zustand eines Stroms, der durch einen Widerstand ($R_X$) zwischen dem FET (60) und der Masse fließt, der gleich der oberen Grenze innerhalb eines Widerstandsbereichs ist, der einem Strombereich entspricht, in dem ein Strom als der Überstrom bestimmt wird, ist, und der Schwellwert niedriger als der Betrag der Drain-Source-Spannung ($V_{DS}$) bei einem gesättigten Zustand eines Stroms, der durch den Widerstand ($R_X$) zwischen dem FET (60) und der Masse fließt, der kleiner als die obere Grenze innerhalb des Widerstandsbereichs ist, ist.

3. Überstromschutzleistungszufuhrvorrichtung (1) nach Anspruch 1 oder 2, bei der die erste überstromschutzsignalerzeugende Schaltung (7) einen Zeitgeber (73) aufweist, der dazu ausgebildet ist, ein Zeitgebersignal während eines vorherbestimmten Zeitgeberzeitraums auszugeben, wenn die Drain-Source-Spannung ($V_{DS}$) größer als ein erster Schwellwert wird, und bei der die erste überstromschutzsignalerzeugende Schaltung (7) dazu ausgebildet ist, das erste Überstromschutzsignal auszugeben, wenn die Drain-Source-Spannung ($V_{DS}$) für einen vorherbestimmten Zeitraum größer als ein zweiter Schwellwert, der größer als der erste Schwellwert ist, bleibt, oder wenn die Anzahl der Zeitgebersignale, die von dem Zeitgeber (73) ausgegeben werden, eine vorherbestimmte Anzahl erreicht.

4. Überstromschutzleistungszufuhrvorrichtung (1) nach einem der Ansprüche 1 bis 3, bei der die drain-source-spannungserfassende Schaltung (2) eine erste Source-Folgerschaltung, eine zweite Source-Folgerschaltung, eine schwellwertfestlegende Schaltung und einen Komparator aufweist, bei der
die erste Source-Folgerschaltung einen ersten p-Typ-MOSFET (28) aufweist, eine Source des ersten p-Typ-MOSFET (28) mit einer Elektrode des FET (60), die mit der Last (66) verbunden ist, über einen ersten Widerstand (25) verbunden ist, und ein gemeinsames Gate-Potential an ein Gate des ersten p-Typ-MOSFET (28) angelegt wird,
die zweite Source-Folgerschaltung einen zweiten p-Typ-MOSFET (26) aufweist, eine Source des zweiten p-Typ-MOSFET (26) mit einer anderen Elektrode des FET (60), die mit der Gleichstromleistungsquelle (63) verbunden ist, über einen zweiten Widerstand (23), der einen Widerstandswert gleich einem Widerstandswert des ersten Widerstands (25) aufweist, verbunden ist, und das gemeinsame Gate-Potential an ein Gate des zweiten p-Typ-MOSFET (26) angelegt wird, und bei der die zweite Source-Folgerschaltung derart ausgebildet ist, dass ein Drain-Strom des zweiten p-Typ-MOSFET (26) gemäß einem Wert, der durch Subtrahieren des Schwellwerts, der zu jener Zeit verwendet wird, von der Drain-Source-Spannung ($V_{DS}$) bezogen wird, variiert,
die schwellwertfestlegende Schaltung dazu ausgebildet ist, imstande zu sein, den Drain-Strom des zweiten p-Typ-MOSFET (26) durch Aufnehmen eines Stroms, der gemäß einem elektrischen Potential der Elektrode des FET (60), die mit der Gleichstromleistungsquelle (63) verbunden ist, variiert, von der Source des zweiten p-Typ-MOSFET (26) zu variieren, und
der Komparator dazu ausgebildet ist, zu erfassen, dass der Drain-Strom des zweiten p-Typ-MOSFET (26) größer als der Drain-Strom des ersten p-Typ-MOSFET (28) wird.

5. Überstromschutzleistungszufuhrvorrichtung (1) nach einem der Ansprüche 1 bis 4, bei der ein n-Typ-MOSFET als der FET (60) verwendet wird,
und bei der die Drain-Source-Spannungserfassungsstartschaltung (4) dazu ausgebildet ist, einen drain-source-spannungserfassenden Betrieb der drain-source-spannungserfassenden Schaltung (2) zu starten, wenn ein elektrisches Potential eines Gate des n-Typ-MOSFET größer als ein elektrisches Potential eines Drain des n-Typ-MOSFET wird.

6. Überstromschutzleistungszufuhrvorrichtung (1) nach einem der Ansprüche 1 bis 4, bei der ein p-Typ-MOSFET als der FET (60) verwendet wird,
und bei der die Drain-Source-Spannungserfassungsstartschaltung (4) dazu ausgebildet ist, einen drain-source-spannungserfassenden Betrieb der drain-source-spannungserfassenden Schaltung (2) zu starten, wenn ein elektrisches Potential eines Gate des p-Typ-MOSFET kleiner als ein elektrisches Potential eines Drain des p-Typ-MOSFET wird.

7. Überstromschutzleistungszufuhrvorrichtung (1) nach einem der Ansprüche 1 bis 6, ferner mit einer Konstantspannungsschaltung (9), bei der die Konstantspannungsschaltung (9) dazu ausgebildet ist, eine Spannung, die an die drain-source-spannungserfassende Schaltung (2) und die Drain-Source-Spannungserfassungsstartschaltung (4) angelegt wird, bei einem konstanten Betrag, der kleiner als eine Spannung der Gleichstromleistungsquelle (63) ist, zu halten.

**Revendications**

1. Appareil d'alimentation électrique avec protection contre les surintensités (1) ayant un circuit d'alimentation électrique (6) pour l'alimentation en énergie électrique à partir d'une source d'alimentation de courant continu (63) à une charge (66) par l'intermédiaire d'un FET (60) et un circuit de commande (16) pour commander le FET (60), dans lequel le circuit de commande (16) est configuré pour désactiver le FET (60) afin de protéger le circuit d'alimentation électrique (6) contre une surintensité, l'appareil (1) comprenant
un circuit de détection de tension drain-source (2) qui est configuré pour détecter une tension drain-source ($V_{DS}$) générée entre un drain et une source du FET (60) par un courant de drain ($I_D$) circulant à travers le FET (60),

un circuit de démarrage de détection de tension drain-source (4) qui est configuré pour démarrer le fonctionnement de la détection de tension de drain-source du circuit de détection de tension drain-source (2) après que la tension drain-source ($V_{DS}$) augmente selon une augmentation du courant de drain ($I_D$) du FET (60) lors de l'allumage du FET (60), et

un premier circuit de génération de signal de protection contre les surintensités (7) qui est configuré pour délivrer un premier signal de protection contre les surintensités en fonction de la tension drain-source ($V_{DS}$) détectée par le circuit de détection de tension drain-source (2), **caractérisé par le fait que**

un second circuit de génération de signal de protection contre les surintensités (8) qui est configuré pour délivrer un second signal de protection contre les surintensités en fonction de l'augmentation du taux de la tension drain-source ($V_{DS}$) détectée par le circuit de détection de tension drain-source (2),

dans lequel le second circuit de génération de signal de protection contre les surintensités (8) est configuré pour mesurer un intervalle de temps entre un moment où la tension drain-source ($V_{DS}$) devient supérieure à une première valeur de seuil et un moment où la tension drain-source ($V_{DS}$) devient supérieure à une troisième valeur de seuil qui est plus grande que la première valeur de seuil et est configuré pour définir un intervalle de temps de référence qui est plus long que l'intervalle de temps mesuré, et dans lequel le second circuit de génération de signal de protection contre les surintensités (8) est configuré pour délivrer le second signal de protection contre les surintensités lorsque la tension drain-source ($V_{DS}$) devient supérieure à une quatrième valeur de seuil qui est supérieure à la troisième valeur seuil à l'intérieur de l'intervalle de temps de référence à partir du moment où la tension drain-source ($V_{DS}$) devient supérieure à la première valeur de seuil, et

dans lequel le circuit de commande (16) est configuré pour désactiver le FET (60) lorsque le premier signal de protection contre les surintensités est délivré par le premier circuit de génération de signal de protection contre les surintensités (7) ou le second signal de protection contre les surintensités est délivré par le second circuit de génération de signal de protection contre les surintensités.

2. Appareil d'alimentation électrique avec protection contre les surintensités (1) ayant un circuit d'alimentation électrique (6) pour l'alimentation en énergie électrique à partir d'une source d'alimentation de courant continu (63) à une charge (66) par l'intermédiaire d'un FET (60) et un circuit de commande (16) pour commander le FET (60), dans lequel le circuit de commande (16) est configuré pour désactiver le FET (60) afin de protéger le circuit d'alimentation électrique (6) contre une surintensité, l'appareil (1) comprenant

un circuit de détection de tension drain-source (2) qui est configuré pour détecter une tension drain-source ($V_{DS}$) générée entre un drain et une source du FET (60) par un courant de drain ($I_D$) circulant à travers le FET (60),

un circuit de démarrage de détection de tension drain-source (4) qui est configuré pour démarrer le fonctionnement de la détection de tension drain-source du circuit de détection de tension drain-source (2) après que la tension drain-source ($V_{DS}$) augmente selon une augmentation du courant de drain ($I_D$) du FET (60) lors de l'allumage du FET (60), et

un premier circuit de génération de signal de protection contre les surintensités (7) qui est configuré pour délivrer un premier signal de protection contre les surintensités en fonction de la tension drain-source ($V_{DS}$) détectée par le circuit de détection de tension drain-source (2), dans lequel

le circuit de commande (16) est configuré pour désactiver le FET (60) lorsque le premier signal de protection contre les surintensités est délivré par le premier circuit de génération de signal de protection contre les surintensités (7), et le circuit de détection de tension drain-source (2) est configuré pour détecter la tension drain-source ($V_{DS}$) en comparant une grandeur de la tension drain-source ($V_{DS}$) avec une valeur de seuil qui varie en fonction d'un potentiel électrique d'une électrode du FET (60) qui est connectée à la source d'alimentation de courant continu (63), **caractérisé par le fait que**

la valeur de seuil est égale à la grandeur de la tension drain-source ($V_{DS}$) dans un état saturé d'un courant circulant à travers une résistance ($R_x$) entre le FET (60) et la masse qui est égale à la limite supérieure d'une plage de résistance correspondant à une plage de courant dans laquelle un courant est déterminé comme étant la surintensité, et la valeur seuil est inférieure à la grandeur de la tension drain-source ($V_{DS}$) dans un état saturé d'un courant circulant à travers la résistance (Rx) entre le FET (60) et la masse qui est inférieure à la limite supérieure de la plage de résistance.

3. Appareil d'alimentation électrique avec protection contre les surintensités (1) selon la revendication 1 ou 2 dans lequel le premier circuit de génération de signal de protection contre les surintensités (7) comporte une minuterie (73) qui est configurée pour délivrer un signal de minuterie pendant une période de minuterie prédéterminée lorsque la tension drain-source ($V_{DS}$) devient supérieure à une première valeur de seuil, et dans lequel le premier circuit de génération de signal de protection contre les surintensités (7) est configuré pour délivrer le premier signal de protection contre les surintensités lorsque la tension de drain-source ($V_{DS}$) continue pendant une période prédéterminée à être supérieure à une seconde valeur de seuil qui est supérieure à la première valeur de seuil ou lorsque le nombre des signaux de minuterie délivrés par la minuterie (73) atteint un nombre prédéterminé.

4.  Appareil d'alimentation électrique avec protection contre les surintensités (1) selon l'une des revendications 1 à 3, dans lequel le circuit de détection de tension drain-source (2) comporte un premier circuit suiveur source, un second circuit suiveur source, un circuit de réglage de valeur de seuil et un comparateur, dans lequel
le premier circuit suiveur source possède un premier MOSFET de type P (28), une source du premier MOSFET de type P (28) est connectée à une électrode du FET (60) qui est connectée à la charge (66) par l'intermédiaire d'une première résistance (25) et un potentiel de grille commune est appliqué à une grille du premier MOSFET de type P (28),
le second circuit suiveur source possède un second MOSFET de type P (26), une source du second MOSFET de type P (26) est connecté à une autre électrode du FET (60) qui est connectée à la source d'alimentation en courant continu (63) par l'intermédiaire d'une seconde résistance (23) ayant une résistance égale à une résistance de la première résistance (25) et le potentiel de grille commun est appliqué à une grille du second MOSFET de type P (26), et dans lequel le second circuit suiveur source est configuré de telle sorte qu'un courant de drain du second MOSFET de type P (26) varie en fonction d'une valeur dérivée en soustrayant la valeur seuil utilisée à ce moment-là par la tension drain-source ($V_{DS}$),
le circuit de réglage de valeur de seuil est configuré de manière à pouvoir faire varier le courant de drain du second MOSFET de type P (26) en captant un courant, qui varie en fonction d'un potentiel électrique de l'électrode du FET (60) qui est connectée à la source d'alimentation de courant continu (63), à partir de la source du second MOSFET de type P (26), et
le comparateur est configuré pour détecter que le courant de drain du second MOSFET de type P (26) devient supérieur au courant de drain du premier MOSFET de type P (28).

5.  Appareil d'alimentation électrique avec protection contre les surintensités (1) selon l'une des revendications 1 à 4 dans laquelle un MOSFET de type N est utilisé comme FET (60),
et dans lequel le circuit de démarrage de détection de tension drain-source (4) est configuré pour démarrer un fonctionnement de détection de tension drain-source du circuit de détection de tension drain-source (2) lorsqu'un potentiel électrique d'une grille du MOSFET de type N devient supérieur à un potentiel électrique d'un drain du MOSFET de type N.

6.  Appareil d'alimentation électrique avec protection contre les surintensités (1) selon l'une des revendications 1 à 4 dans lequel un MOSFET de type P est utilisé comme FET (60),
et dans lequel le circuit de démarrage de détection de tension drain-source (4) est configuré pour démarrer un fonctionnement de détection de tension drain-source du circuit de détection de tension drain-source (2) lorsqu'un potentiel électrique d'une grille du MOSFET de type P devient inférieur à un potentiel électrique d'un drain du MOSFET de type P.

7.  Appareil d'alimentation électrique avec protection contre les surintensités (1) selon l'une des revendications 1 à 6 comprenant en outre un circuit à tension constante (9), dans lequel le circuit à tension constante (9) est configuré pour maintenir une tension qui est appliquée au circuit de détection de tension drain-source (2) et le circuit de démarrage de détection de tension drain-source (4) à une grandeur constante qui est inférieure à une tension de la source d'alimentation en courant continue (63).

## FIG. 1

FIG. 2

EP 2 846 464 B1

FIG. 3

FIG. 4

EP 2 846 464 B1

FIG. 5

## FIG. 6

## FIG. 7

FIG. 8

EP 2 846 464 B1

# FIG. 9

（1）

（2）

**EP 2 846 464 B1**

**REFERENCES CITED IN THE DESCRIPTION**

**Patent documents cited in the description**

- EP 1693942 A1
- US 20110019323 A1
- JP 3706515 B